# EUROPEAN PATENT SPECIFICATION

(11) **EP 2 901 594 B1**
(45) Date of publication and mention of the grant of the patent: **02.11.2016**
(21) Application number: 13783110.3
(22) Date of filing: 27.09.2013
(51) Int. Cl.: H04L 1/00, H03M 13/09, H04B 14/06, G10L 19/005, H03M 3/04, G10L 19/02, H03M 7/30

(54) **ERROR DETECTION FOR SUB-BAND ADPCM ENCODED SOUND SIGNAL**
FEHLERERKENNUNG IN EINEM TEILBAND ADPCM-KODIERTEN TONSIGNAL
DETECTION D'ERREUR DANS UN SIGNAL SONORE ENCODE PAR MICDA

(30) Priority: 28.09.2012 JP 2012215890
(43) Date of publication of application: 05.08.2015
(73) Proprietor: Panasonic Intellectual Property Management Co., Ltd., Osaka-shi, Osaka 540-6207 (JP)
(72) Inventor: SHIBUTA, Akira, Osaka-shi, Osaka 540-6207 (JP); SUWA, Yutaka, Osaka-shi, Osaka 540-6207 (JP); ISHIHARA, Hiroyuki, Osaka-shi, Osaka 540-6207 (JP); OBANA, Kyoichi, Osaka-shi, Osaka 540-6207 (JP)
(74) Representative: Eisenführ Speiser
(86) International application number: PCT/JP2013/077016
(87) International publication number: WO 2014/051166

(56) References cited:
- EP-A1- 2 383 895
- US-A1- 2005 143 985
- US-A1- 2010 138 724
- US-B1- 6 301 558
- BALAZS KOVESI ET AL: "A low complexity packet loss concealment algorithm for ITU-T G.722", ACOUSTICS, SPEECH AND SIGNAL PROCESSING, 2008. ICASSP 2008. IEEE INTERNATIONAL CONFERENCE ON, IEEE, PISCATAWAY, NJ, USA, 31 March 2008 (2008-03-31), pages 4769-4772, XP031251665, ISBN: 978-1-4244-1483-3

## Description

### Technical Field

The present invention relates to a wireless communication device and a communication terminal that perform a communication by use of sound packets.

### Background Art

When a user carries a wireless voice communication system in one's hand, such as a cellular phone and a cordless phone, or uses the system at a location where ambient circumstances change, variations occur in received signal strength indicator, a distance between devices, and an interference radio wave, which greatly affects communication quality. A known countermeasure against the problems is; for instance, a technique described in relation to a wireless telephone system as disclosed in Patent Literature 1.

The wireless telephone system of Patent Literature 1 is made up of a base unit that has a base transceiver and at least one wireless handset and that is connectable with one external phone line. The wireless handset and the base unit implement communication by means of fixed-size audio packets, each of which is composed of a plurality of audio data samples and error correction bits. Moreover, Patent Literature 1 includes descriptions about changing a relative number of bits assigned to an audio data sample and an error correction bit in connection with a packet configuration of a subsequent audio packet by means of monitoring the quality of a digital link set on a wireless channel and determining whether or not a change has occurred in error rate.

Specifically, when the error rate becomes worse, the wireless telephone system performs processing for decreasing an amount of data pertinent to an audio data sample contained in a packet and increasing an amount of data pertinent to error correction bits to thus assign a larger number of bits to error correction, thereby broadening a distance range and enhancing a tolerance to the interference radio wave.

Patent Literature 2 discloses a technique of reversing least significant bits in "n" bits in accordance with the number of "1s" in the "n" bits of n-bit ADPCM data, thereby letting the least significant bits act like a parity signal and enabling detection of an error without involvement of an increase in the number of bits. As a result, when a communication environment becomes worse, sound quality is somewhat distorted, but accuracy in error detection is increased. When an error occurs in ADPCM data, the ADPCM data themselves can be switched to a muted or attenuated state.

In addition, Patent Literature 3 discloses a technique of converting an ADPCM code for which an error is detected into an ADPCM code which may cause a much smaller amplitude change in a decoded signal, thereby preventing occurrence of high-level unusual noise and avoiding a situation in which a level of a normal decoded sound will fall more than necessary to thus prevent a listener from feeling unpleasant sensation.

Patent Literature 4 discloses a method of error protection of wireless communication of packets of sampled digitized audio data comprising identifying the least significant bits of each sample of audio data encoded with an ADPCM scheme in packets and selectively replacing one or more of the least significant bits with values that enable performing error correction on the rest of the data encoded in the packet.

### Citation List

### Patent Literature

Patent Literature 1: JP-T-2002-509387
Patent Literature 2: JP-A-2010-154163
Patent Literature 3: JP-A-7-143074
Patent Literature 4: US2010/0138724 A1.

### Summary of Invention

### Technical Problem

When the error rate is increased as a result of deterioration of the communication environment, the wireless telephone system described in connection with Patent Literature 1 switches a quality level from the highest quality level to an intermediate quality level or a low quality level by decreasing a data rate of sound in order to increase the amount of data pertinent to the error correction bits. For this reason, sound quality is considered to become deteriorated. However, if the sound quality changes for the worse in sequence as the communication environment becomes worse, the user will experience inconvenience in using the wireless telephone system.

Moreover, the techniques described in connection with Patent Literature 2 and Patent Literature 3 make it possible to perform audio processing that inhibits muting of a sound or occurrence of unpleasant unusual noise, which would otherwise arise at the time of occurrence of an error, without greatly degrading sound quality even when the communication environments become worse, thereby preventing the listener from feeling unpleasant sensation. In the meantime, these techniques are based on the premise that the system uses a signal band employed in a popular telephone line. However, even in the field of wireless communication, a demand exists for extending a frequency band to a broader band to implement communication of more natural sound quality.

Accordingly, an object of the present invention is to provide a wireless communication device and a communication terminal that can maintain sound quality without changing a sound data rate through use of a fixed-size packet even when the communication environments become worse and, hence, can enhance accuracy in error detection.

### Solution to Problem

The present invention proposes a communication terminal defined in accordance with claim 1.

### Advantageous Effects of Invention

According to the present invention, in a wireless wideband voice communication, high frequency ADPCM data and low frequency ADPCM data are individually processed by means of an error detection code that is transmitted after replacement of some of bits of the low range ADPCM data. Therefore, even when the communication environments become worse, wideband sound quality can be maintained by a fixed-size packet without changing a data rate of sound.

### Brief Description of Drawings

Fig. 1 is a block diagram showing a cordless telephone according to an embodiment of the present invention.
Fig. 2 is a block diagram for explaining a low frequency ADPCM encoder of the cordless telephone according to the embodiment of the present invention.
Fig. 3 is a diagram showing a layout of sound data in a sound packet of the cordless telephone according to the embodiment of the present invention.
Fig. 4 is a diagram for explaining a transmission conversion table of the cordless telephone according to the embodiment of the present invention.
Fig. 5 is a diagram for explaining a transmission conversion table switching unit of the cordless telephone according to the embodiment of the present invention.
Fig. 6 is a diagram showing a format of the sound packet and the layout of the sound data in the sound packet of the cordless telephone according to the embodiment of the present invention.
Fig. 7 is a diagram for explaining tables pertinent to a low frequency signal in a reception conversion table of the cordless telephone according to the embodiment of the present invention.
Fig. 8 is a diagram for explaining tables pertinent to a high frequency signal in the reception conversion table of the cordless telephone according to the embodiment of the present invention.
Fig. 9 is a diagram for explaining a reception conversion table switching unit of the cordless telephone according to the embodiment of the present invention.
Fig. 10 is a block diagram for explaining a low frequency ADPCM decoder of the cordless telephone according to the embodiment of the present invention.
Fig. 11 is a diagram for explaining sound processing using a related-art sound packet.
Fig. 12 is a diagram for explaining sound processing using a sound packet of the cordless telephone according to the embodiment of the present invention.
Figs. 13A and 13B are diagrams showing counters disposed in a receiving error processing unit of the cordless telephone according to the embodiment of the present invention.
Fig. 14 is a flowchart for explaining reception conversion table switching operation of the cordless telephone according to the embodiment of the present invention.
Fig. 15 is a flowchart for explaining the reception conversion table switching continued from Fig. 14.
Fig. 16 is a diagram for explaining reception table switching operation that is determined by means of received signal strength.
Fig. 17 is a diagram for explaining reception conversion table switching that is determined by a frame error counter.
Figs. 18A and 18B are diagrams showing an example of received data processing of the cordless telephone according to the embodiment of the present invention.
Fig. 19 is a diagram showing the example of received data processing of the cordless telephone according to the embodiment of the present invention.

### Description of Embodiments

### (Embodiment)

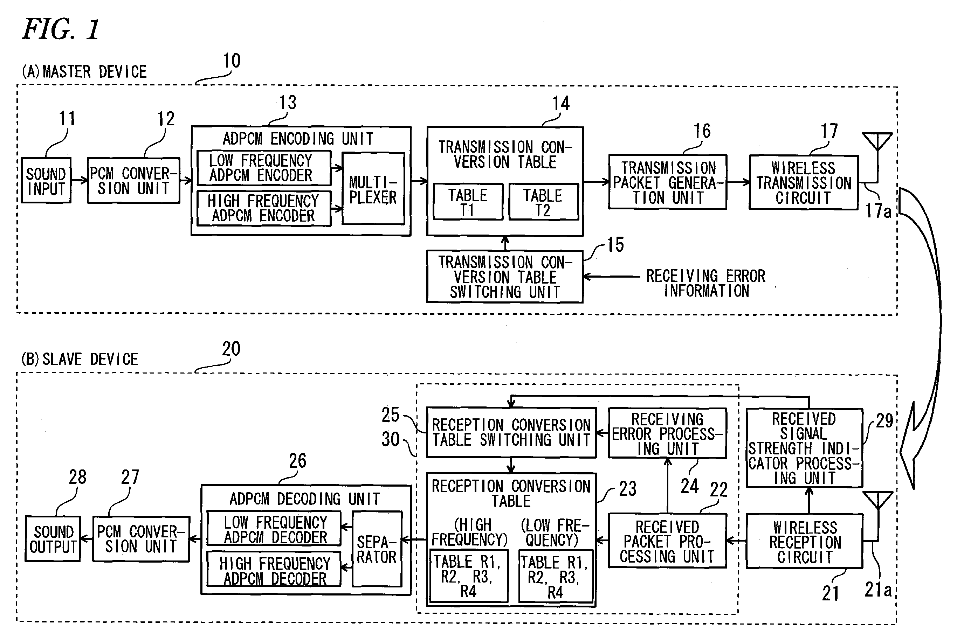

By reference to the drawings, a wireless communication device according to an embodiment of the present invention is described by taking a cordless telephone as an example. Fig. 1 is a block diagram showing a cordless telephone according to an embodiment of the present invention. In Fig. 1, (A) is a block diagram showing a transmission function of a master device (a first communication terminal), and (B) is a block diagram showing a receiving function of a slave device (a second communication terminal). For the sake of convenience, Fig. 1 illustrates only the transmission function of the master device and the receiving function of the slave device. However, each of the master device and the slave device has both functions.

The cordless telephone includes the master device 10 and one or more slave devices 20, as shown in Fig. 1. The cordless telephone is a wireless communication device that establishes a digital link on a wireless channel between the master device 10 and the slave device 20; that compresses a sound signal by adaptive pulse code modulation; and that performs a communication while containing the thus-compressed sound signal in a sound packet by means of TDMA (Time Division Multiple Access)/TDD (Time Division Duplex). G.722 that is the ITU-T (International Telecommunication Union Telecommunication Standardization Sector) recommendation is adopted for the codec.

The master device 10 includes a sound input unit 11, a PCM conversion unit 12, an ADPCM encoding unit 13, a transmission conversion table 14, a transmission conversion table switching unit 15, a transmission packet generation unit 16, and a wireless transmission circuit 17.

The sound input unit 11 inputs a sound signal formed from signal that is delivered by way of a telephone line network or an IP network. The sound input unit 11 corresponds to a microphone that is built in a handset if the master device 10 is provided with the handset.

The PCM conversion unit 12 samples the sound signal at a predetermined cycle and quantizes the thus-sampled signal into an integral value including a predetermined number of bits.

The ADPCM encoding unit 13 generates digital sound data (hereinafter referred to simply as "sound data") by means of G.722 wideband ADPCM (Adaptive Differential Pulse Code Modulation). The ADPCM encoding unit 13 first separates input data into a high frequency signal and a low frequency signal by means of a quadrature mirror filter and performs ADPCM encoding on the high frequency signal and the low frequency signal, respectively.

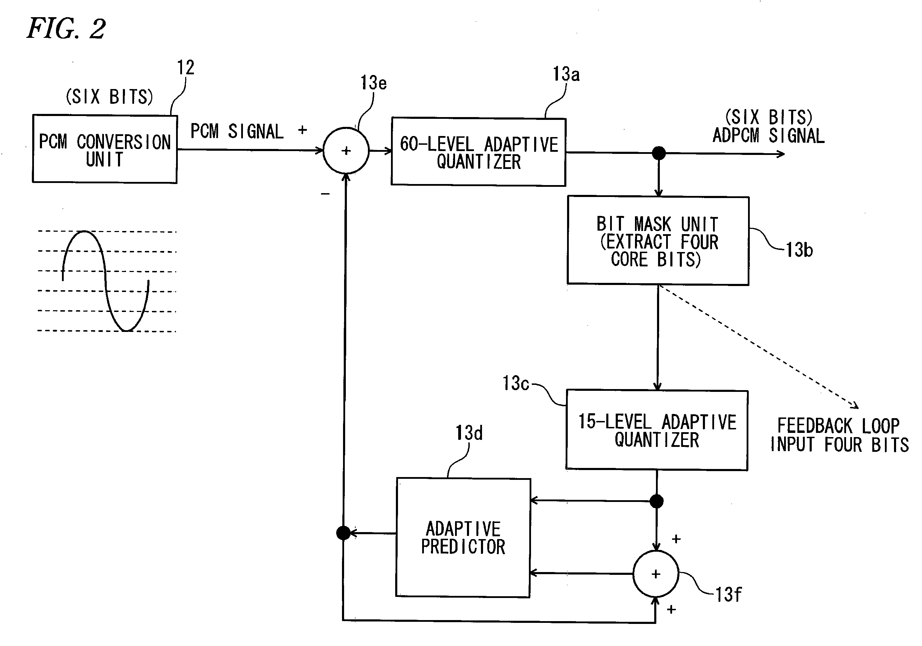

Fig. 2 is a diagram for explaining a low frequency ADPCM encoder of the ADPCM encoding unit 13. The low frequency ADPCM encoder shown in Fig. 2 includes a 60-level adaptive quantizer 13a, a bit mask unit 13b, and a 15-level adaptive dequantizer 13c, and an adaptive predictor 13d. The bit mask unit 13b extracts bits which are set as core bits, from a 6-bit low frequency ADPCM code generated by the adaptive quantizer 13a. In the embodiment, four higher order bits are set as core bits and input to a feedback loop.

The 15-level adaptive dequantizer 13c calculates a quantized differential signal from data pertinent to the core bits (four bits), outputting a calculation result. The differential signal output from the 15-level adaptive dequantizer 13c is delivered to the adaptive predictor 13d and an adder 13f. The adder 13f adds a prediction signal generated in the encoder to the differential signal, to thus generate a regenerative signal. The adaptive predictor 13d generates a prediction signal from the differential signal originating from the 15-level adaptive dequantizer 13c and the regenerative signal originating from the adder 13f.

An input signal sent from the PCM conversion unit 12 is delivered to the adder 13e, and the adder 13e calculates a difference between the input signal sent from the PCM conversion unit 12 and the prediction signal sent from the adaptive predictor 13d. A resultant difference signal generated by the adder 13e is delivered to the 60-level adaptive quantizer 13a, and the 60-level adaptive quantizer 13a generates a 6-bit low frequency ADPCM code.

In the meantime, the high frequency ADPCM encoder performs 2-bit high frequency ADPCM encoding on an input high frequency signal according to G.722 standards. The high frequency ADPCM encoder does not have a bit mask unit and is configured so as to input all bits into the adaptive dequantizer. The high frequency ADPCM encoder can be analogous to the low frequency ADPCM encoder except this configuration, and hence its detailed explanations using the drawings are omitted.

The ADPCM encoding unit 13 multiplexes the thus-generated 6-bit low frequency ADPCM code and the 2-bit high frequency ADPCM code by use of a multiplexer as shown in Fig. 1, thereby generating an 8-bit wideband ADPCM code.

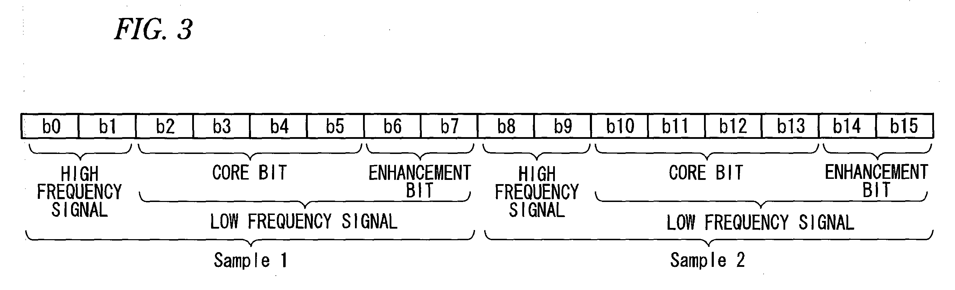

In the embodiment, the ADPCM encoding unit 13 of the master device 10 generates ADPCM data that are a low frequency signal having a data rate of 48 kbps. In the ADPCM data, low frequency sound data are assigned six bits, and highest order bits include a positive code bit and a negative code bit. Accordingly, as shown in Fig. 3, the 6-bit low frequency ADPCM data are represented as 000000 to 111111. Since the ADPCM data represent a difference between data that have been digitized immediately before and the current data. Hence, 000000 designates the positive minimum value, and 111111 designates the negative minimum value. In addition, 011111 denotes the positive maximum value, and 100000 designates the negative maximum value.

In conformance with G.722 standards, four bits of the 6-bit low frequency ADPCM code are set as core bits, and remaining two bits are set as enhancement bits in the embodiment. Specifically, the ADPCM encoding unit 13 generates ADPCM data while taking four higher order bits as core bits, and the decoding unit of the receiving side also performs decoding operation while taking the four higher order bits as core bits. As above, so long as the same number of core bits is set on the encoder and the decoder, respectively, a prediction signal generated by the adaptive predictor 13d assumes the same value at both the encoder and the decoder. Accordingly, even when enhancement bits are used in another application, like a data communication, great degradation of sound quality cannot be avoided.

In Fig. 1, the wideband ADPCM code generated by the ADPCM encoding unit 13 is delivered to the transmission conversion table 14, and the transmission conversion table 14 converts the 4-bit sound data output from the ADPCM encoding unit 13 into 4-bit transmission data to be output to the slave device 20.

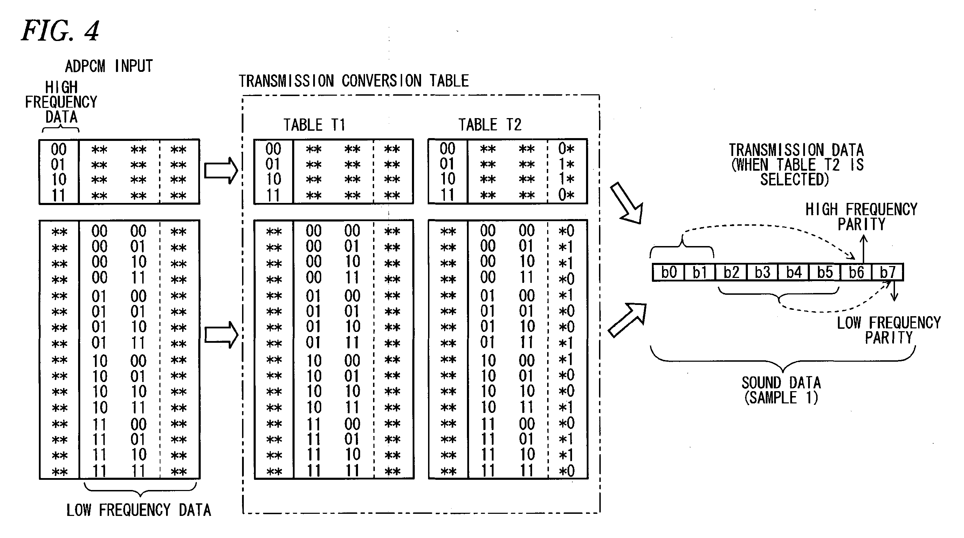

Fig. 4 is a diagram for explaining the transmission conversion table 14. The transmission conversion table 14 is now described in detail by reference to Fig. 4. The transmission conversion table 14 contains a table T1 and a table T2. When receiving condition is excellent, the table T1 is employed, and input sound data are output while assuming exactly the same value. When receiving error information on the receiving side reaches a predetermined level, the table T2 is used. The table T2 is configured such that two bits of the high frequency ADPCM data and four higher order bits among six bits of the low frequency ADPCM data respectively assume exactly the same values as their originally input values and that two lower order bits act as even parity bits for the two bits of the high frequency ADPCM data and the four higher order bits of the low frequency ADPCM data, respectively.

In short, in relation to the two lower order bits of the table T2; namely, b6 (the next least significant bit (LSB)) and b7 (the least significant bit), the "next least significant bit" is reversed such that the number of "1s" in the two bits becomes even according to the number of "1s" in the two bits of the high frequency ADPCM data, and the "least significant bit" is reversed such that the number of "1s" in the four bits become even according to the number of "1s" in the four higher order bits of the low frequency ADPCM data, thereby letting the two bits act as a parity signal. By means of converting the sound data by use of the table T2, the two lower order bits b6 and b7 of eight bits per one sample value of a sound data sequence to be transmitted; for instance, eight bits b0, b1, ..., b7 shown in Fig. 3, act as a parity signal.

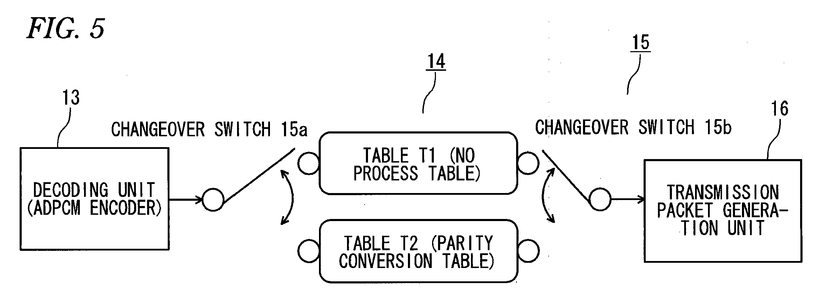

In Fig. 1, the transmission conversion table switching unit 15 performs switching between two tables (the table T1 and the table T2) of the transmission conversion table 14 according to the receiving error information sent from the slave device 20. Fig. 5 is a diagram for explaining the transmission conversion table switching unit 15. A function of the transmission conversion table switching unit 15 is now described by reference to Fig. 5.

By use of a changeover switch 15a intended for connection with the ADPCM encoding unit 13 and a changeover switch 15b intended for connection with the transmission packet generation unit 16, the transmission conversion table switching unit 15 toggles between the table T1 and the table T2 in accordance with the receiving error information so as to apply any one of the tables to the ADPCM encoding unit 13 and the transmission packet generation unit 16. When an excellent communication environment is maintained and when there is no need for transmission conversion, the changeover switches 15a and 15b are switched to the table T1. When transmission conversion is required as a result of deterioration of the communication environment, the changeover switches 15a and 15b are switched to the table T2, thereby converting transmission data such that two lower order bits of the transmission data act as a parity signal.

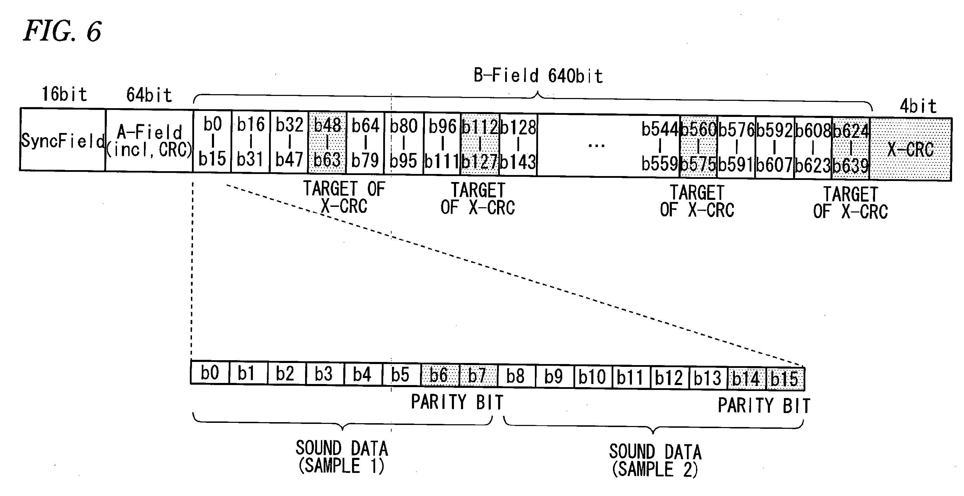

In Fig. 1, the transmission packet generation unit 16 accumulates sound data output from the transmission table 14 by an amount corresponding to 10 msec, thereby generating a sound packet. By reference to Fig. 5, the sound packet is described. Fig. 6 is a diagram showing a format of the sound packet and a configuration of a field for storing sound data in the embodiment.

The sound packet shown in Fig. 6 is made up of a sync field (16 bits) where sync data (a sync word) are to be stored, a field A (48 bits) where control signal data are to be stored, a field-A CRC (16bits) where a CRC (Cyclic Redundancy Check) for the field A is to be stored, a field B (640 bits) where sound data are to be stored, and a field-B CRC (four bits) where a CRC for the field B is to be stored.

In the embodiment, wideband ADPCM sound data to be stored in the field B are assigned eight bits per sample value, and two lower order bits (b6, b7) of the eight bits are allocated for a parity signal. In addition, two higher order bits (b0, b1) are assigned for high frequency ADPCM data, and subsequent four bits (b2, ..., b5) are assigned for four core bits of the lower frequency ADPCM code.

Further, in the embodiment, when conversion is carried out by reference to the table T2, the transmission side sends per sample, as low frequency ADPCM data, 5-bit data that are made up of four bits of ADPCM data (core bits) and one least significant bit that is to act as a parity bit. The transmission side also sends per sample, as high frequency ADPCM data, 3-bit data that are made up of two bits of ADPCM data and one next least significant bit that is to act as a parity bit. Thus, the transmission side transmits both the parity bit for a low frequency signal and the parity bit for a high frequency signal without changing the number of bits (eight bits) per sample.

The CRC for the field B does not take the entirety of 320-bit field B as a target and partially takes only data pertinent to predetermined bit positions as a target. To be specific, the field-B CRC takes, as a target, sound data that are distributed in ten locations every 16 bits. The sound data are only a total of 160 bits that are represented by bit numbers: b48 to b63, b112 to b127, b176 to b191, ..., b560 to b575, and b624 to b639.

In Fig. 1, the wireless transmission circuit 17 functions as a transmission circuit unit that modulates the sound packet output from the transmission packet generation unit 16 into a wireless signal and that transmits the wireless signal from the antenna 17a.

As above, in the master device 10, data transmission section is configured by the transmission conversion table 14 that converts a portion of the ADPCM sound data into a parity bit, the transmission packet generation unit 16 that generates a sound packet including the thus-converted sound data, and the wireless transmission circuit 17 that transmits the sound packet as a wireless signal to the slave device 20.

The slave device 20 is now described by reference to (B) in Fig. 1. The slave device 20 includes a wireless reception circuit 21 and an antenna 21a. A signal received by the wireless reception circuit 21 is processed by a received data processing unit 30, whereupon the thus-processed signal is output as high frequency ADPCM data and low frequency ADPCM data. The received data processing unit 30 is provided with a received packet processing unit 22, a reception conversion table 23, a receiving error processing unit 24, and a reception conversion table switching unit 25. Further, the slave device 20 is provided with the ADPCM decoding unit 26, a PCM conversion unit 27, a sound output unit 28, and a received signal strength indicator processing unit 29.

The wireless reception circuit 21 acts as a reception circuit unit that receives by way of an antenna 21a the wireless signal output from the master device 10, demodulates the thus-received signal, and outputs the thus-demodulated signal as a sound packet to the received packet processing unit 22. The wireless reception circuit 21 measures a received strength indicator (RSSI) of the received sound packet, outputting the thus-measured indicator to received field strength processing.

The received packet processing unit 22 detects a sync error when a predetermined sync word is not acquired, a CRC error for the field A or the field B, and a parity error in sound data, sending the error to the receiving error processing unit 24 and extracting the sound data and outputting the thus-extracted sound data to the reception conversion table 23.

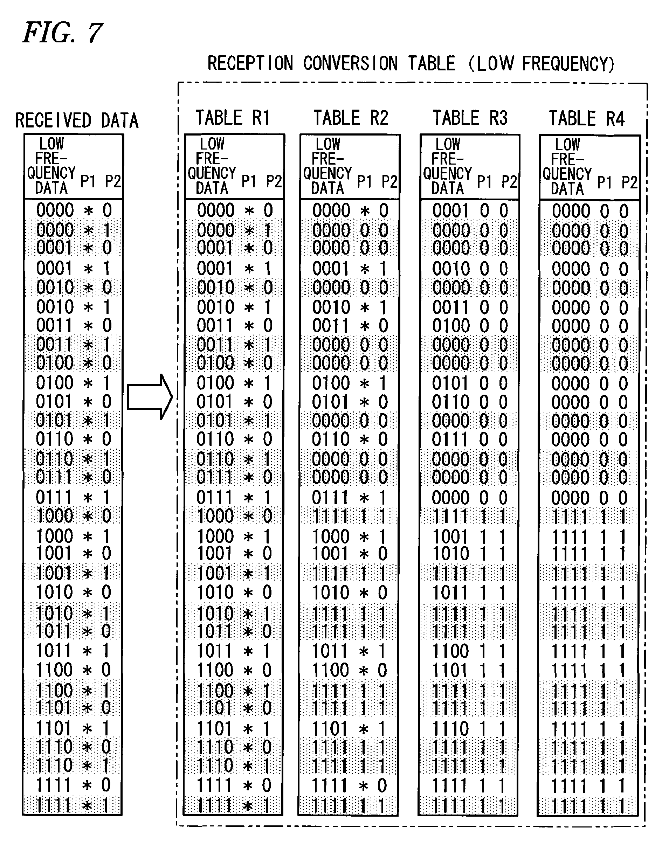

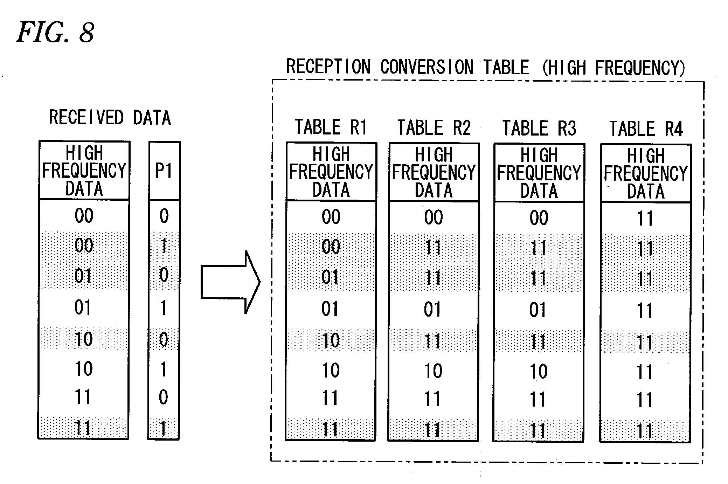

The reception conversion table 23 converts the 4-bit sound data received from the master device 10, outputting a conversion result. By reference to Fig. 7 and Fig. 8, the reception conversion table 23 is now described in detail.

Fig. 7 is a diagram for explaining a table pertaining to a low frequency signal in the reception conversion table 23, and Fig. 8 is a diagram for explaining a table pertaining to a high frequency signal. As shown in Fig. 7 and Fig. 8, the reception conversion table 23 includes tables R1 to R4 for each of a low frequency signal and a high frequency signal. In any event, the table R1 is configured so as to output input sound data in exactly the same values.

In Fig. 7 and Fig. 8, the table R2 is configured so as to replace the sound data with mute data when results on the parity check of the two bits of the high frequency ADPCM data and the six bits of the low frequency ADPCM data show occurrence of a parity error. In conformance with an even parity rule, the transmission side (the master device 10) identifies occurrence of a high frequency parity error by means of the number of "1s" in a total of three bits; namely, the two bits of the high frequency ADPCM data and the "next least significant bit P1." Specifically, a parity error is identified by means of "001," "010," and "111" that include an odd number of 1s. Likewise, occurrence of a low frequency parity error is identified by means of the number of "1s" in a total of five bits; that is, four higher order bits of the low frequency ADPCM data and the "least significant bit P2."

During the conversion performed by the table R2 of the reception conversion table 23, sound data are exactly output without change unless a parity error occurs. In contrast, if occurrence of a parity error is identified (when the number of "1s" in target bits is determined to be odd), sound data are replaced with mute data. In the embodiment, high frequency signal mute data are assigned "11," and low frequency signal mute data are assigned "111111" or "000000." However, the mute data are not limited to them, and another mute data can also be used. As above, in response to occurrence of a parity error, the reception conversion table 23 converts the sound data including the error with mute data, thereby preventing reproduced sound from being affected by the error.

In connection with high frequency data, the table R3 converts data including a parity error with mute data as does the table R2. In addition to this, in connection with low frequency data, the table R3 is configured so as to add one to four higher order bits of data that are free of an error, thereby replacing the data with sound data that will attenuate a sound. In the case of; for instance, "1001," "1010," and "1100," they are converted into "1010," "1011," and "1101" by addition of one.

The table R4 is configured so as to replace all of the sound data with mute data regardless of occurrence of the parity error; in other words, the high frequency data with "11" and the low frequency data with "111111" or "000000."

In (B) of Fig. 1, the receiving error processing unit 24 is an error determination section that has a counter (to be described in detail later) which performs count-up operation at the time of occurrence of a reception error, such as a sync error detected by the receiving packet processing unit 22, a field A error, and a field B error and which performs count-down operation at the time of occurrence of no error. A value of the counter is sent to the reception conversion table 25, whereupon the reception conversion table 23 is switched in accordance with the counter value.

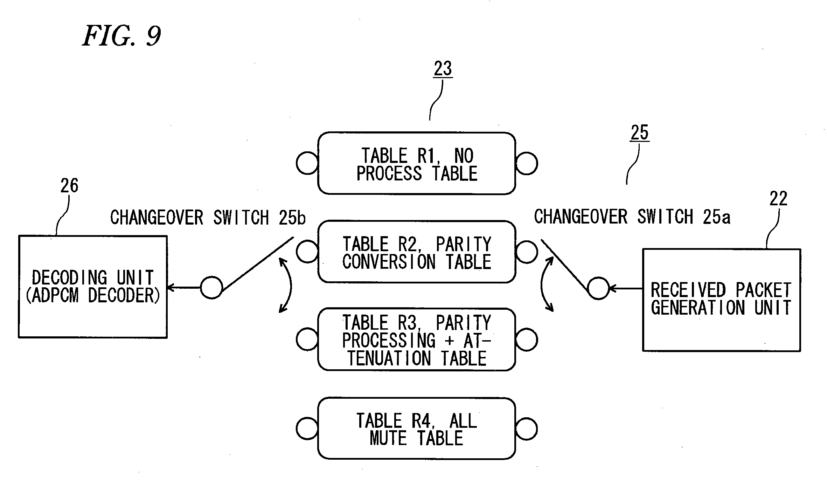

The reception conversion table switching unit 25 acts as a data conversion section (a receiving side processing unit) along with the reception conversion table 23 by switching among four tables (the tables R1 to R4) of the reception conversion table 23 in accordance with a command from the slave device 20 by way of the receiving error processing unit 24 or a received signal strength indicator signal originating from the received signal strength indicator processing unit 29. The reception conversion table switching unit 25 is now described by reference to Fig. 9. Fig. 9 is a diagram for explaining the reception conversion table switching unit 25.

By means of changeover switches 25a and 25b, the reception conversion table switching unit 25 switches among the tables (R1 to R4) used in the reception conversion table 23. For instance, when conversion processing is not performed, the received packet processing unit 22 and the ADPCM decoding unit 26 are switched to the table R1. In the meantime, when parity processing is practiced, the received packet processing unit 22 and the ADPCM decoding unit 26 are switched to the table R2. In addition, when parity processing and attenuation processing are performed, the received packet processing unit 22 and the ADPCM decoding unit 26 are switched to the table R3.

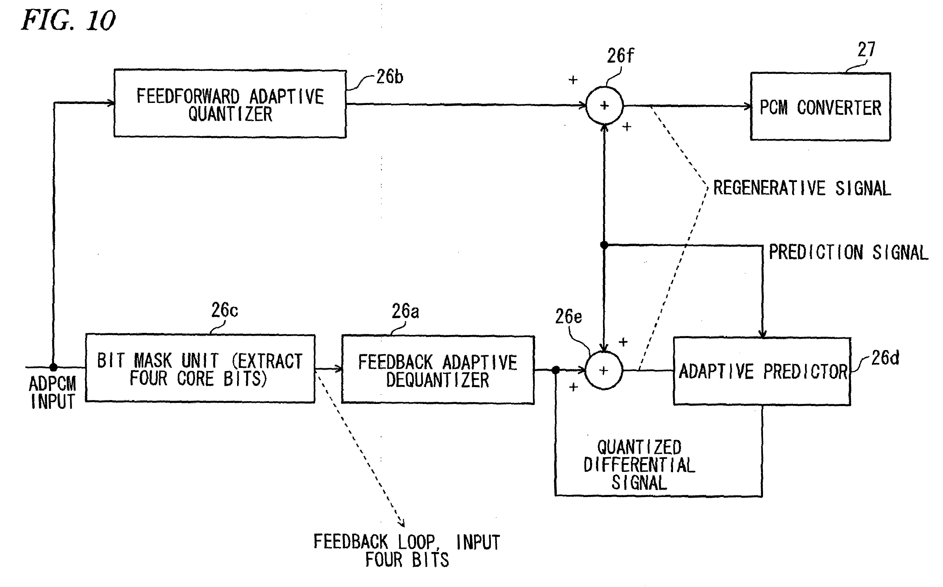

The ADPCM decoding unit 26 shown in (B) of Fig. 1 separates 8-bit input data sent from the reception conversion table 23 into a high frequency signal and a low frequency signal by means of a separator, subsequently performing ADPCM decoding on the respective signals. In other words, even when the 8-bit data include two lower order bits of parity bits and the mute data, all of the eight bits are decoded into sound data. The ADPCM decoding unit 26 is now described by reference to Fig. 10.

Fig. 10 is a diagram for explaining a low frequency ADPCM decoder of the ADPCM decoding unit 26. The low frequency ADPCM decoder shown in Fig. 10 is now described. The low frequency ADPCM decoder includes a feedback adaptive dequantizer 26a, a feedforward adaptive dequantizer 26b, a bitmask unit 26c, and an adaptive predictor 26d. The bitmask unit 26c extracts core bits from the ADPCM code input, and only the thus-extracted core bits are input to the feedback adaptive dequantizer 26a. The feedback adaptive dequantizer 26a calculates a quantized differential signal, outputting the thus-calculated, quantized differential signal. The thus-output, quantized differential signal is added to the prediction signal by the adder 26e, and a result of addition is input to the adaptive predictor 26d, where a prediction signal is generated.

The feedforward adaptive quantizer 26b calculates a quantized differential signal by use of all bits in the ADPCM data, outputting a calculation result. When the low frequency sound data are 48 kbps, a 6-bit ADPCM code input is output. The adder 26f adds the prediction signal calculated only from the core bits to the quantized differential signal calculated from all six bits, whereby a low frequency regenerative signal is output.

In the meantime, the essential requirement for the high frequency ADPCM decoder of the ADPCM decoding unit 26 is to perform processing conforming to the known G722 standard. The bitmask unit is not necessary, and all of the bits are input to the adaptive dequantizer. The high frequency ADPCM decoder is analogous to the low frequency ADPCM decoder except absence of the bitmask unit, and hence its detailed explanations are unnecessary.

The ADPCM decoding unit 26 combines the thus-decoded low frequency signal and the high frequency signal together by means of a receiving rectangular mirror filter, to thus generate a wideband sound signal. Even when a parity bit is transmitted without changing the number of bits per sample (eight bits), the receiving side uses the low frequency ADPCM data as they are without changing four core bits thereof to generate a prediction signal. The receiving side also processes the high frequency ADPCM data while taking them as two bits, so that deterioration of sound quality is small and a conversation can be performed while a certain degree of sound quality is maintained.

In (B) of Fig. 1, the PCM conversion unit 27 generates an analog sound signal from the reproduction signal. The sound output unit 28 may be a speaker that reproduces the sound signal, for example.

The received electric field strength processing unit 29 functions as the received electric field strength level determination means that determines the change of the received electric field strength measured by the wireless reception circuit 21 and outputs the result of the determination to the reception conversion table switching unit 25. This determination is made in a manner such that, in the case where the master device 10 and the slave device 20 are spaced apart from each other, the received electric field strength is lowered, and if the received electric field strength is lower than a threshold value A (a first threshold value), the communication environment is inferior. Further, in the case where the master device 10 and the slave device 20 are close to each other, the communication environment becomes good and the received electric field strength is elevated. If the received electric field strength exceeds a threshold value B (a second threshold value), the communication environment becomes good. However, in determination, the threshold value B is set to be higher than the threshold value A.

The received electric field strength processing unit 29 outputs information on the communication environment to the reception conversion table switching unit 25, and the reception conversion table switching unit 25 selects the table R1 that does not perform the parity check if the communication environment is good. Further, if the communication environment is inferior, the reception conversion table switching unit 25 performs the parity check (the transmission side: table T2), the reception side selects any one of other tables (tables R2 to R4) to be sound-processed. The received electric field strength processing unit 29 performs the synchronization between the master device 10 and the conversion table by transferring the determination result information that is obtained by determining the change of the received electric field strength to the master device 10 using a control packet.

By setting the threshold value B to be larger than the threshold value A, switching is performed from the table R1 in which the parity check is not performed to the tables R2 to R4 in which the parity check is performed and the sound process is performed when the communication environment is deteriorated, and even if the communication environment becomes good thereafter, the switching is not performed at the same electric field strength as that switched by the reception conversion table 23. Since the parity check is stopped after the communication environment reaches a sufficiently good level, the reception conversion table 23 and the transmission conversion table 14 are prevented from being frequently switched.

A communication method of the cordless telephone as configured above according to the embodiment of the present invention will be described based on the drawings. First, in communication between the master device 10 and the slave device 20, a case where the communication environment is good and no reception error occurs will be described. In this case, it is assumed that the table T1 illustrated in Fig. 4 is selected in the transmission conversion table 14, and the table R1 illustrated in Figs. 7 and 8 is selected in the reception conversion table 23.

The sound signal from the sound input unit 11 is quantized by the PCM conversion unit 12, and one code is compressed into 8-bit sound data through ADPCM by the ADPCM encoding unit 13.

This 8-bit sound data is input to the table T1 of the transmission conversion table 14, and then the sound data having the same value as the input is output from the table T1 as the transmission data. The sound data output from the transmission conversion table 14 is included in the sound packet by the transmission packet generation unit 16, and is transmitted to the slave device 20 through the antenna 17a by the wireless transmission circuit 17 as the wireless signal.

In the slave device 20, the wireless signal from the master device 10 is received in the wireless reception circuit 21 through the antenna 21a. The wireless signal received in the wireless reception circuit 21 is demodulated and output to the received packet processing unit 22 as the sound packet.

The received packet processing unit 22 checks the occurrence of the reception error of the sound packet, extracts the 8-bit sound data included in the sound packet, and outputs the extracted sound data to the reception conversion table 23.

If the sound data is input to the table R1 of the reception conversion table 23, 8 bit sound data having the same value as the input is output from the table T1. The sound data output from the reception conversion table 23 is input to and expanded by the ADPCM decoding unit 26, converted into a sound signal by the PCM conversion unit 27, and is reproduced by the sound output unit 28.

In this case, since the master device 10 that is the transmission side transmits the sound to the slave device 20 as it is without processing all the 8-bit ADPCM sound data, high-quality sound can be transmitted.

Next, a case where the slave device 20 detects the reception error will be described.

If the received packet processing unit 22 of the slave device 20 detects the reception error such as a sync error or a CRC error, it transmits reception error information regarding the effect that the reception error has occurred to the master device 10 using a transmission function (not illustrated). The master device 10 can recognize that the communication environment is deteriorated through the notification of the reception error information. Accordingly, the transmission conversion table switching unit 15 performs switching of the connections of the transmission conversion table 14 to be applied between the ADPCM encoding unit 13 and the transmission packet generation unit 16 from the table T1 to the table T2. By doing so, the two lower order bits of the 8-bit sound data is converted into the parity bit (see Fig. 3). The parity bit generation using the transmission conversion table 14 is simpler than the parity bit calculation through operation.

The slave device 20 instructs, in synchronization with the notification of the reception error to the master device 10, the reception conversion table switching unit 25 to perform switching of the reception conversion table 23 from the table R1 to the table R2. That is, the reception conversion table 23 is switched to the table R2 as a reception conversion table pertinent to the low frequency signal as shown in Fig. 7, and switched to the table R2 as a reception conversion table pertinent to the high frequency signal as shown in Fig. 8. As described above, the conversion by the table R2 is performed in a manner such that the sound data is output as it is if the parity error has not occurred, and the sound data is converted into the mute data if the parity error has occurred.

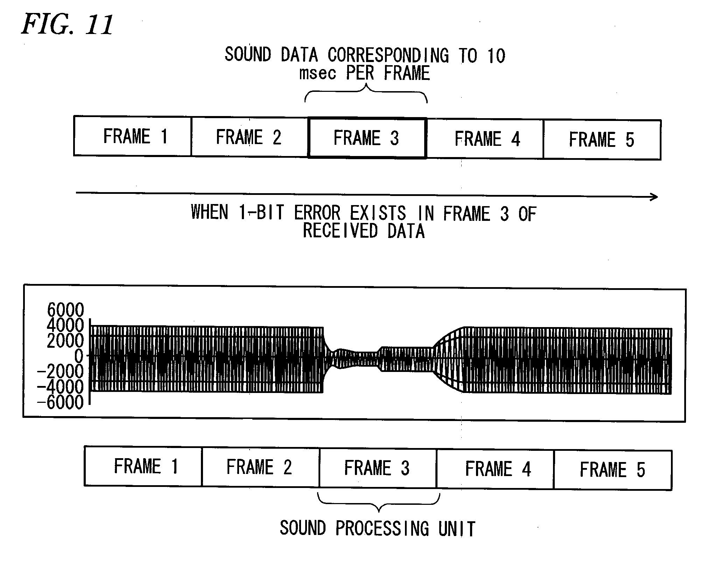

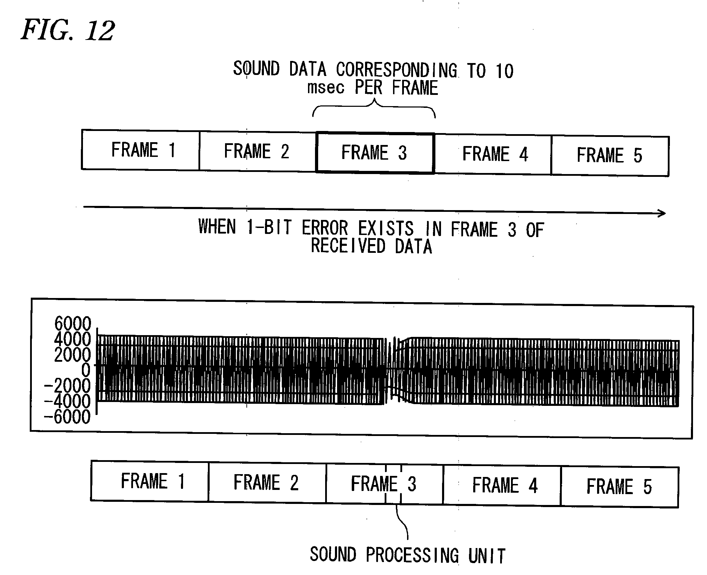

Next, the influence on the sound packet in the related art and the influence on the sound of the sound packet according to the embodiment of the present invention will be described based on Figs. 11 to 12. Fig. 11 is a diagram illustrating sound processing in a sound packet in the related art. Fig. 12 is a diagram illustrating sound processing in a sound packet according to the embodiment of the present invention.

In the sound packet in the related art as illustrated in Fig. 11, since a CRC of a B-field is added to 16-bit sound data that is distributed in ten locations in the B-field, sound data that is not the subject of the CRC is present, and the reception error for all the sound data may not be detected. Accordingly, even in the case where not only the CRC error of the B-field but also the error of data for synchronization and the CRC error (CRC error of an A-field) added to data for a control signal are detected, it is necessary to perform the sound process such as mute with respect to the entire one frame on the assumption that there is a high possibility that the error has occurred even in the sound data that is not the subject of the CRC of the B-field. As illustrated in Fig. 11, sound data of about 10 msec is included in one frame, and if the sound data for one frame is processed, it exerts a great influence on the sound.

In the sound packet according to the embodiment, a parity bit is added for each 8-bit sound data, and thus the error can be detected every 8 bits. Accordingly, as illustrated in Fig. 12, by converting only the sound data in which the parity error has occurred into the mute data, it is not required to perform the sound process with respect to the whole one frame. In a conventional method in which a CRC is added to 16-bit sound data that is distributed in about ten locations in the B-field of one frame of a sound packet, it is required to perform sound processing such as muting with respect to the whole of one frame if the CRC error is detected. On the other hand, according to the embodiment, it is possible to detect an error in a minute unit in a sound packet and replace the sound packet. Thus, since the influence range corresponds to only the replaced sound data, it exerts a low influence on the sound.

The sound data output from the reception conversion table 23 is input to and expanded by the ADPCM decoding unit 26, converted into a sound signal by the PCM conversion unit 27, and is reproduced by the sound output unit 28. In reproducing the sound, since the two lower order bits are used as the parity bit while the data rate is maintained, the sound quality is somewhat deteriorated in comparison to the case where all the 8 bits are used as the sound data, but high sound quality can be secured in comparison to the case where sound data for one frame is processed in a state of the sync word error or the CRC error due to the deterioration of the communication environment.

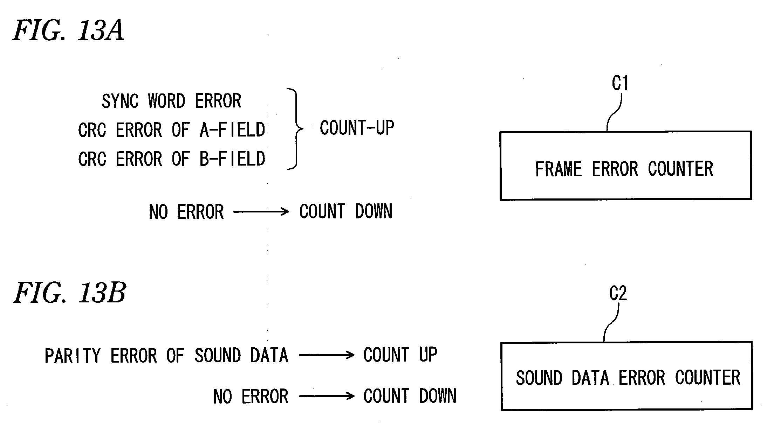

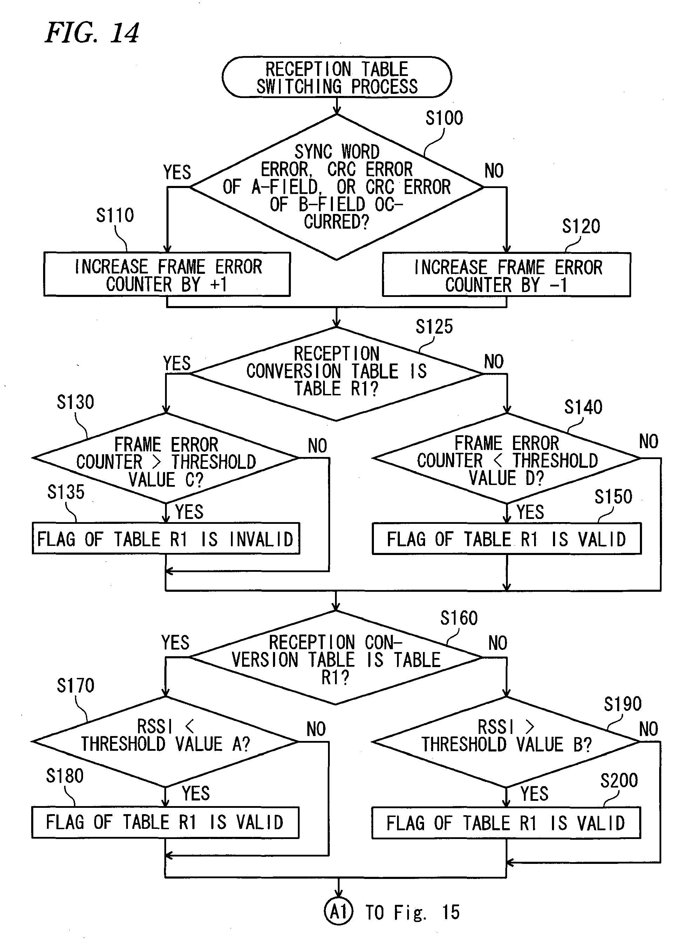

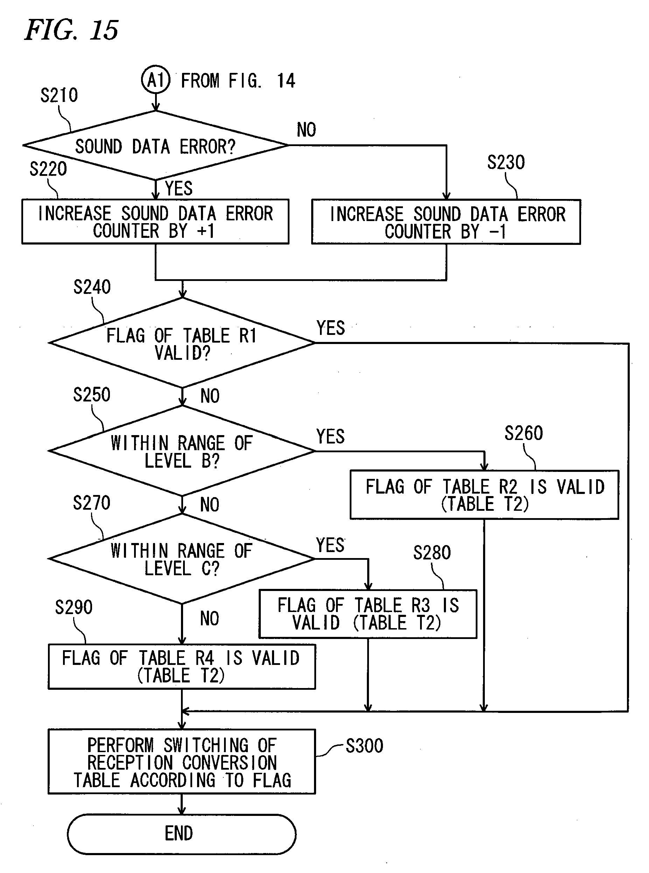

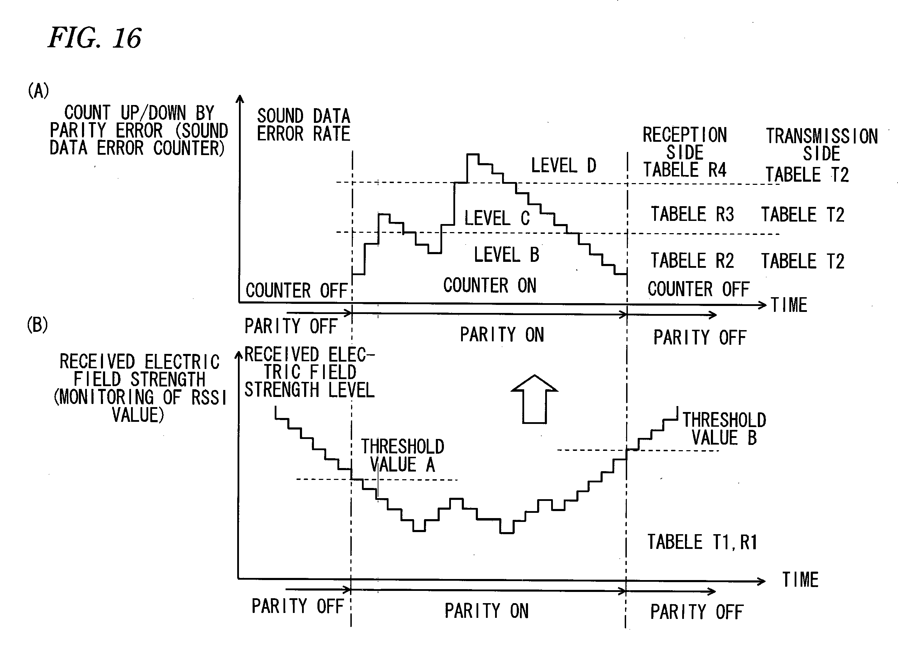

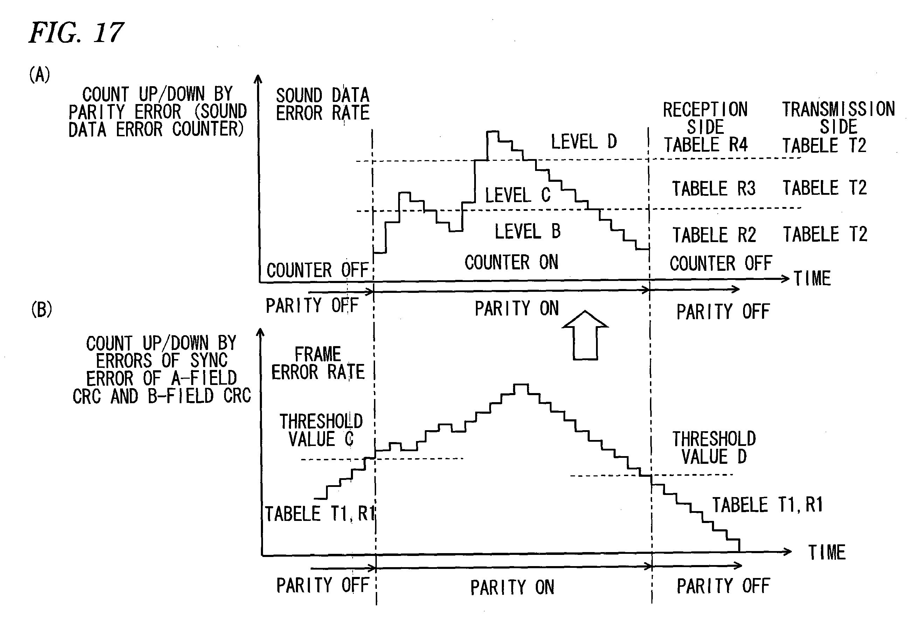

Next, a method of switching transmission and reception conversion tables that is performed by the reception error processing unit 24 will be described based on Figs. 13A to 17. Figs. 13A and 13B are diagrams illustrating a counter installed in the reception error processing unit 24. Fig. 13A is a diagram illustrating a frame error counter, and Fig. 13B is a diagram illustrating a sound data error counter. Fig. 14 is a flowchart illustrating a reception conversion table switching process, and Fig. 15 is a flowchart illustrating a reception conversion table switching process continuously performed from Fig. 14. Fig. 16 is a diagram illustrating a reception conversion table switching process that is determined by the received electric field strength, and Fig. 17 is a diagram illustrating a reception conversion table switching process that is determined by a frame error counter.

As shown in Figs. 13A and 13B, the reception error processing unit 24 has two counters that count number according to the contents of error notification from the received packet processing unit 22. These counters include, as illustrated in Fig. 13A, a frame error counter C1 that counts up by the sync word error, A-field CRC error, or B-field CRC error and counts down by no error, and, as illustrated in Fig. 13B, a sound data error counter C2 that counts up when the 8-bit sound data is the parity error and counts down by no error. In this embodiment of the present invention, count-up corresponds to +1 and count-down corresponds to 1. However, the count-up/down may be set to have different values in order to change the weight. It is possible to appropriately determine these values according to the communication environment where the cordless telephone is installed.

As illustrated in Fig. 14, the reception error processing unit 24 determines whether or not the frame system error, such as the sync word error, A-field CRC error, or B-field CRC error, has occurred in the received packet processing unit 22 (S100). If the error has occurred, the reception error processing unit 24 increases the frame error counter C1 by +1 (S110), while if the error has not occurred, the reception error processing unit 24 increases the frame error counter C1 by -1 (S120).

Next, the reception error processing unit 24 determines whether or not the reception conversion table 23 that is currently used is the table R1 (S125). If the reception conversion table 23 is the table R1, the reception error processing unit 24 determines whether or not the frame error counter value is equal to or larger than a threshold value C (S130). If the frame error counter value is equal to or larger than the threshold value C, the reception error processing unit 24 invalidates a flag of the table R1 (S135). That is, as illustrated in Fig. 17, since the error is increased due to an interference radio wave or the like, the reception error processing unit 24 invalidates the flag of the table R1, and performs switching of the reception conversion table 23 from the table R1 that does not perform the parity check to the tables R2 to R4 that perform the parity check or the sound processing. By doing so, the reception error processing unit 24 can detect the error of the sound data that occurs according to the deterioration of the communication environment at high accuracy If the frame error counter value is smaller than the threshold value C in S130, the table R1 of the reception conversion table 23 is used as the current state, and the flag of the table R1 is in a valid state.

Further, if it is determined that the reception conversion table 23 that is currently used is not the table R1 in S125 as illustrated in Fig. 14, the reception error processing unit 24 determines whether or not the frame error counter value is smaller than a threshold value D (S140). If the frame error counter value is smaller than the threshold value D, the reception error processing unit 24 validates the flag of the table R1 (S150). That is, as illustrated in Fig. 17, in the case where no error has occurred due to the nonexistence of the interference radio wave, the reception error processing unit 24 validates the flag of the table R1, and performs switching of the reception conversion table 23 from the tables R2 to R4 that perform the parity check or the sound processing to the table R1 that does not perform the parity check. By doing so, the communication environment becomes good, and thus communication of the sound data can be performed with a better sound quality If the frame error counter value is not smaller than the threshold value D in S140, the tables R2 to R4 of the reception conversion table 23 are used as the current state, and the flag of the table R1 is in an invalid state.

Next, the received electric field strength processing unit 29 determines whether or not the reception conversion table 23 currently used is the table R1 (S160). If the reception conversion table 23 is the table R1, the received electric field strength processing unit 29 determines whether or not the received electric field strength measured by the wireless reception circuit 21 is lower than the threshold value A (S170). If the received electric field strength is lower than the threshold value A, the received electric field strength processing unit 29 invalidates the flag of the table R1 (S180). That is, as illustrated in Fig. 16, since the received electric field strength is lower than the threshold value A due to the long distance between the master device 10 and the slave device 20 or the like, the received electric field strength processing unit 29 invalidates the flag of the table R1, and performs the switching of the reception conversion table 23 from the table R1 that does not perform the parity check to the tables R2 to R4 that perform the parity check or the sound processing. By doing so, the received electric field strength processing unit 29 can detect the error of the sound data that occurs according to the deterioration of the communication environment at high accuracy. If the received electric field strength is not smaller than the threshold value Ain S170, the table R1 of the reception conversion table 23 is used as the current state, and the flag of the table R1 is in a valid state.

Further, if it is determined that the reception conversion table 23 currently used is not the table R1 in S160 shown in Fig. 14, the received electric field strength processing unit 29 determines whether or not the received electric field strength is equal to or higher than the threshold value B (S190). If the received electric field strength is equal to or higher than the threshold value B, the received electric field strength processing unit 29 validates the flag of the table R1 (S200). That is, as illustrated in Fig. 16, since the received electric field strength is equal to or higher than the threshold value B due to the short distance between the master device 10 and the slave device 20 or the like, the received electric field strength processing unit 29 validates the flag of the table R1, and performs the switching of the reception conversion table 23 from the tables R2 to R4 that perform the parity check or the sound processing to the table R1 that does not perform the parity check. By doing so, the communication environment becomes good, and thus communication of the sound data can be performed with a better sound quality. If the received electric field strength is smaller than the threshold value B in S190, the tables R2 to R4 of the reception conversion table 23 are used as the current state, and the flag of the table R1 is in an invalid state.

Next, as illustrated in Fig. 15, the reception error processing unit 24 determines whether or not the sound data error that is the parity error of the sound data has occurred (S210). If the error has occurred, the reception error processing unit 24 increases the sound data error counter C2 by +1 (S220), while if the error has not occurred, the reception error processing unit 24 increases the sound data error counter C2 by -1 (S230).

Next, the reception error processing unit 24 determines whether or not the flag of the table R1 is valid (S240). If the flag of the table R1 is valid, it means that the frame error rate is low and the communication environment is good, and thus regardless of the count value of the sound data error counter C2, the side of the master device 10 is switched to the table T1 and the side of the slave device 20 proceeds to S300 to be switched to the table R1.

Next, the reception error processing unit 24 determines whether or not the sound data error counter C2 is within a range of the level B (S250). This level B is in a range where the frame system error rate has been elevated, but the sound data error rate is determined to be still low. Accordingly, in order to perform the parity check of the sound data, the reception conversion table 23 validates the flag of the table R2 that selects the table R2 (S260), and then proceeds to S300.

If the sound data error counter C2 is not within the range of the level B, the reception error processing unit 24 then determines whether or not the sound data error counter C2 is within the range of the level C (S270). This level C is in a range where it is determined that the sound data error rate has been gradually elevated. Accordingly, the reception error processing unit 24 validates the flag of the table R3, which selects the table R3 that not only replaces the sound data with the mute data in the case where the parity error of the sound data has occurred but also replaces the sound data with the sound data that mutes the high frequency sound and attenuates the low frequency sound even in the case where the parity error has not occurred (S280), and then proceeds to S300.

If the sound data error counter C2 is not within the range of the level C, it means that the sound data error counter C2 is within the level D, and the reception error processing unit 24 validates the flag of the table R4. This level D is in the range where the communication environment is worst. Accordingly, the table R4 which replaces all the sound data with the mute data is selected in the reception conversion table 23 (S290).

In S300, the reception error processing unit 24 performs the switching of the reception conversion table 23 according to the flag. For example, if the flag of the table R1 is valid, the reception error processing unit 24 instructs the reception conversion table switching unit 25 to perform switching of the reception conversion table 23 to the table R1. Further, the reception error processing unit 24 transmits a control packet to the master device 10 so that the master device 10 switches the transmission conversion table 14 to the table T1.

Further, if any one of flags of the tables R2 to R4 is valid, the reception error processing unit 24 instructs the reception conversion table switching unit 25 to perform switching of the reception conversion table 23 to any one of the tables R2 to R4. Further, the reception error processing unit 24 notifies the master device 10 of the error information, and instructs the master device 10 to perform switching of the transmission conversion table 14 to the table T2.

As described above, since the reception error processing unit 24 determines the increase/decrease of the error rate by adding the frame system error, such as the sync word error, the A-field CRC error, or the B-field CRC error, to the parity error of the sound data, it can cope with the occurrence of the error with higher accuracy

Further, if it is determined that the error has occurred by the parity bit value of the sound data, the reception error processing unit 24 makes the sound data error counter C2 count up, while if it is determined that the error has not occurred, the reception error processing unit 24 makes the sound data error counter C2 count down. By increasing/decreasing the error rate by the sound data error counter C2, the reception error processing unit 24 can cope with the communication environment in which the reception level is deteriorated or becomes good.

Further, in the table R2 of the reception conversion table 23, the sound data in which the parity error has occurred is converted into the mute data. However, a click noise may occur depending on the sound data. Accordingly, by performing switching of the reception conversion table 23 to the table R3, the sound data for which the error does not occur in the same frame is converted so that the sound is attenuated, and thus the influence of the click noise can be suppressed.

Further, in the case where the communication environment is further deteriorated, by performing switching of the reception conversion table 23, which converts the whole sound data in the same frame into the mute data, to the table R4, the click noise can be suppressed more effectively.

As described above, the embodiment of the present invention has been described thus far, but the present invention is not limited to the embodiment. For instance, in the embodiment, the high frequency signal is muted by means of a parity error for a high frequency signal, and the low frequency signal is muted by means of a parity error for a low frequency signal. However, both the high frequency signal and the low frequency signal can be muted by means of either of the two parity errors.

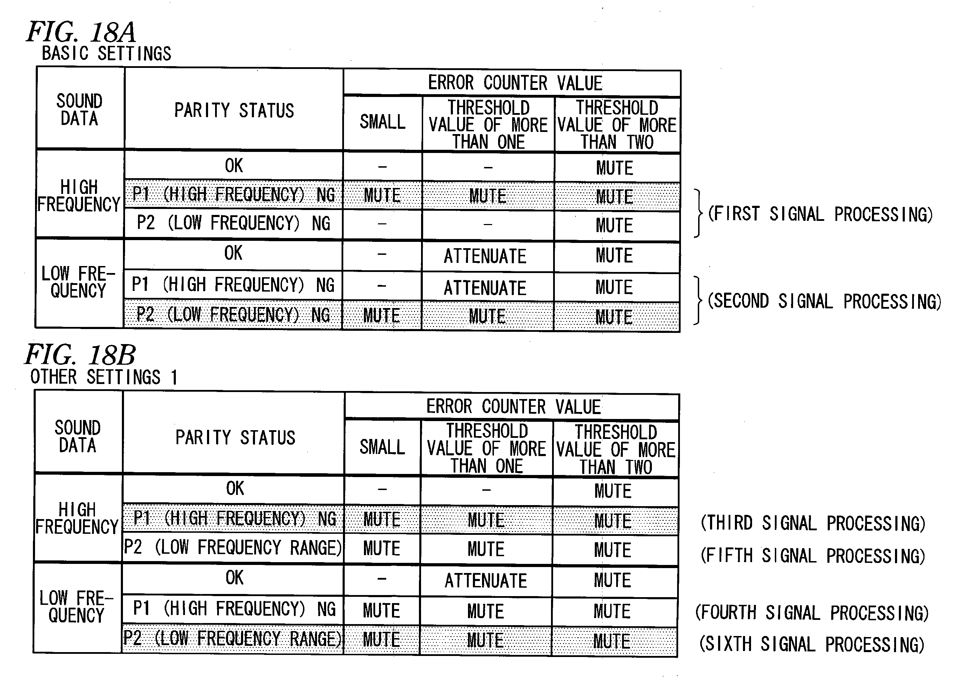

Figs. 18A and 18B are diagrams collectively showing an example of received data processing used for setting the reception conversion table 23. Explanations are hereunder provided along Figs. 18A and 18B.

In an example shown in Fig. 18A, when a sound data error counter C2 in the receiving error processing unit 24 shows "low" or "level B" that is below a threshold value of one, "mute" processing is performed for a high frequency sound when the high frequency signal parity bit P1 represents "NG." "Mute" processing is performed for a low frequency sound when a low frequency signal parity bit P2 represents "NG."

In the example shown in Fig. 18A, when the sound data error counter C2 shows "level C" or a threshold value which is more than one to less than two and when the high frequency signal parity bit P1 represents "NG," "mute" processing is performed. Further, in connection with a low frequency sound achieved when the sound data error counter C2 represents "level C," even when the low frequency signal parity bit and the high frequency signal parity bit are normal; namely, "OK," "attenuation" is performed. If the high frequency signal parity bit P1 represents "NG," "attenuation" will be performed. Further, if the low frequency signal parity bit P2 represents "NG," "mute" processing will be performed.

In the example shown in Fig. 18A, when the sound data error counter C2 shows a threshold value of more than two, or deterioration proceeding up to; namely, "level D," both the high frequency signal and the low frequency signal are muted regardless of whether both the low frequency signal parity bit and the high frequency signal parity bit are "OK" or "NG."

In the examples shown in Figs. 18A and 18B, first signal processing corresponds to high frequency sound processing that is practiced when the high frequency signal parity bit P1 represents "NG" or when the low frequency signal parity bit P2 represents "NG." The second signal processing corresponds to low frequency sound processing that is practiced when the high frequency signal parity bit P1 represents "NG" or when the low frequency signal parity bit P2 represents "NG."

In the example shown in Fig. 18B, in a case where the sound data error counter C2 in the receiving error processing unit 24 shows "low" or "level B" that is below a threshold value of one, "mute" processing is performed for a high frequency sound when the high frequency signal parity bit P1 represents "NG" or when the low frequency signal parity bit P2 represents "NG." In a case where the sound data error counter C2 represents "level B," "mute" processing is performed for the low frequency sound when the high frequency signal parity bit P1 represents "NG" or when the low frequency signal parity bit P2 represents "NG."

In the example shown in Fig. 18B, when the sound data error counter C2 shows "level C," or a threshold value which is more than one to less than two, "mute" processing is performed for the high frequency sound if the high frequency signal parity bit P1 represents "NG" or if the low frequency signal parity bit P2 represents "NG." Further, when the sound data error counter C2 represents "level C," "attenuation" processing is performed even when both the low frequency signal parity bit and the high frequency signal parity bit are normal; namely, "OK." In addition, when the low frequency signal parity bit P2 represents "level C," "mute" processing is performed for a low frequency sound if the high frequency signal parity bit P1 represents "NG," and "mute" processing is performed for a low frequency sound if the low frequency signal parity bit P2 represents "NG."

In the example shown in Fig. 18B, when the sound data error counter C2 shows a threshold value of more than two, or deterioration proceeding up to; namely, "level D," both the high frequency signal and the low frequency signal are muted regardless of whether both the low frequency signal parity bit and the high frequency signal parity bit are "OK" or "NG."

Third to fifth signal processing corresponds to the following processing in the example shown in Fig.18B. The third signal processing corresponds to high frequency sound processing that is performed when the high frequency signal parity bit P1 represents "NG." The fifth signal processing corresponds to high frequency sound processing that is performed when the low frequency signal parity bit P2 represents "NG." The fourth signal processing corresponds to low frequency sound processing that is performed when the high frequency signal parity bit P1 represents "NG." In addition, the sixth signal processing corresponds to low frequency sound processing that is performed when the low frequency signal parity bit P2 represents "NG."

In the embodiment, lower order bits of sound data are employed as error detection bits; namely, parity bits. However, the least significant bit can also be generated by means of another error detection method.

In the above embodiment, an error detection code including a total of two bits; namely, the high frequency signal parity bit P1 and the low frequency signal parity bit P2, is generated, and the error detection codes are assigned to two lower order bits of the sound data. However, in another embodiment, only one parity bit of entire data that include both a high frequency signal and a low frequency signal is assigned to the error detection code, and both the high frequency signal and the low frequency signal can also be muted in accordance with the parity error code. Specifically, there may be generated a parity bit (the third parity bit: P3) that reverses bits in accordance with the number of "1s" in a series of data including both high frequency ADPCM data and low frequency ADPCM data, and a least significant bit of the low frequency ADPCM data can be also replaced with the third parity bit P3.

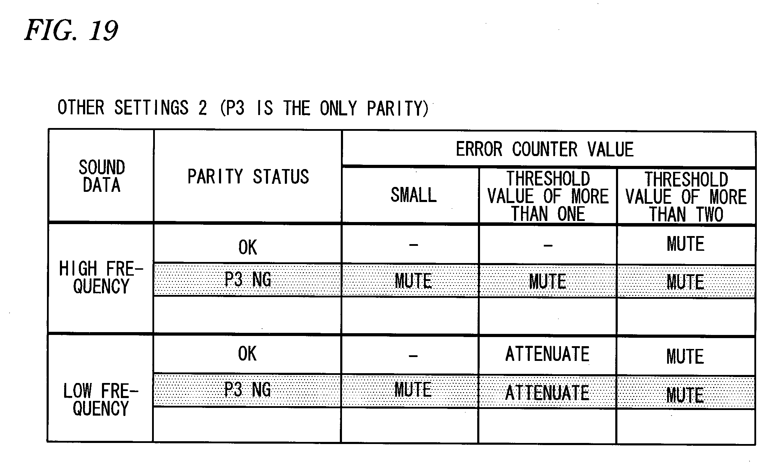

In the embodiment shown in Fig. 19, processing is performed by use of only the parity bit P3. To be specific, if the sound data error counter C2 represents "small," or "level B" which is a threshold value below one, "mute" processing will be performed for high frequency sound if the parity bit P3 represents "NG." Further, "mute" processing will be performed even for a low frequency sound if the parity bit P3 represents "NG."

Moreover, in the embodiment, when the sound data error counter C2 shows "level C," or a threshold value which is more than one to less than two, "mute" processing is performed for the high frequency sound when the high frequency signal parity bit P1 represents "NG." Further, when the sound data error counter C2 represents "level C," "attenuation" processing is performed for the low frequency sound regardless of whether the parity bit P3 is normal, that is, "OK," or "NG."

Furthermore, in the example, when the sound data error counter C2 shows a threshold value of more than two, or deterioration proceeding up to "level D," both the high frequency signal and the low frequency signal are muted regardless of whether the parity bit P3 represents "OK" or "NG."

The present application is based on Japanese Patent Application No. 2012-215890 filed on September 28, 20 12.

### Industrial Applicability

Since the system that is based on a wideband fixed-size sound packet can enhance accuracy in error detection while assuring a certain degree of sound quality when a communication environment becomes worse, the present invention is preferable for a wireless communication device and a communication terminal that practice a communication by means of a wideband sound packet.

### Reference Signs List

10: MASTER DEVICE
11: SOUND INPUT UNIT
12: PCM CONVERSION UNIT
13: ADPCM ENCODING UNIT
14: TRANSMISSION CONVERSION TABLE
15: TRANSMISSION CONVERSION TABLE SWITCHING UNIT
16: TRANSMISSION PACKET GENERATION UNIT
17: WIRELESS TRANSMISSION CIRCUIT
20: SLAVE DEVICE
21: WIRELESS RECEPTION CIRCUIT
22: RECEIVED PACKET PROCESSING UNIT
23: RECEPTION CONVERSION TABLE
24: RECEIVING ERROR PROCESSING UNIT
25: RECEPTION CONVERSION TABLE SWITCHING UNIT
26: ADPCM DECODING UNIT
27: PCM CONVERSION UNIT
28: SOUND OUTPUT UNIT
29: RECEIVED SIGNAL STRENGTH INDICATOR PROCESSING UNIT
30: RECEIVED DATA PROCESSING UNIT

## Claims

1. A communication terminal configuring a wireless communication system that is adapted to establish a digital link on a wireless channel and that is adapted to perform communication by a sound packet which includes a sound signal encoded by adaptive differential pulse code modulation and an error detection code, the communication terminal comprising:
an ADPCM encoding unit that is adapted to divide a sampled sound signal into a high frequency signal and a low frequency signal and to individually encode the high frequency signal and the low frequency signal by means of adaptive differential pulse code modulation to thereby convert the high frequency signal into high frequency ADPCM data having a first number of bits, and convert the low frequency signal into low frequency ADPCM data having a second number of bits;
an error detection code generation unit that is adapted to generate an error detection code pertinent to the high frequency ADPCM data having the first number of bits and the low frequency ADPCM data having the second number of bits;
a transmission data conversion unit that is adapted to replace data pertinent to some of a plurality of bits which configure the low frequency ADPCM data with the error detection code generated by the error detection code generation unit; and
a data transmission unit that is configured to transmit the high frequency ADPCM data and the low frequency ADPCM data which is partially replaced by the data conversion unit to a communication opponent.

2. The communication terminal according to claim 1, wherein
the first number of bits of the high frequency ADPCM data and the second number of bits of the low frequency ADPCM data are fixed, and
the transmission data conversion unit is adapted to replace bits with the error detection code generated by the error detection code generating unit, wherein the replaced bits are selected, except a plurality of bits to be input to an adaptive dequantizer of the ADPCM encoding unit, in data pertinent to the second number of bits which configure the low frequency ADPCM data.

3. The communication terminal according to claim 1, wherein
the error detection code generation unit is adapted to generate a first error detection code pertaining to the high frequent ADPCM data and a second error detection code pertaining to the low frequency ADPCM data, and
the transmission data conversion unit is adapted to replace at least two bits of data among the plurality of bits that configure the low frequency ADPCM data with at least two bits of an error detection code including the first error detection code and the second error detection code.

4. The communication terminal according to claim 3, wherein
the transmission data conversion unit is adapted to replace data pertinent to two lower order bits of the low frequency ADPCM with at least two bits of an error detection code including the first error detection code and the second error detection code.

5. The communication terminal according to claim 1, wherein
the error detection code generation unit is adapted to generate a first error detection code that acts as a parity signal for reversing bits in accordance with the number of "1s" in the high frequency ADPCM data and a second error detection code that acts as a parity signal for reversing bits in accordance with the number of "1s" in the low frequency ADPCM data, or
the error detection code generation unit is adapted to generate a third error detection code that acts as a parity signal for reversing bits in accordance with the number of "1s" in a series of data that include the high frequency ADPCM data and the low frequency ADPCM data.

6. The communication terminal according to claim 1, further comprising
an error determination unit that is adapted to determine a change in error rate of the digital link, wherein
the transmission conversion unit is adapted to select, based on a determination result of the error determination unit, whether to transmit the low frequency ADPCM data to a communication opponent after replacing some of the low frequency ADPCM data with an error detection code or to transmit the low frequency ADPCM data without replacing the some of the low frequency ADPCM data with the error detection code.

7. The communication terminal according to claim 6, wherein
the error determination unit is adapted to increase or decrease the error rate according to a sync data error or an error detected by an error detection bit appended to control signal data or an entirety of a sound packet.

8. The communication terminal according to claim 7, wherein
the error determination unit is adapted to perform count-up of an error counter when occurrence of an error is determined from a value of the error detection bit and count-down of the error counter when an error does not occur, and to increase or decrease the error rate by reference to the error counter.

9. The communication terminal according to claim 8, further comprising
a received signal strength indicator level determination section that is adapted to determine a change in received signal strength indicator by monitoring the digital link, wherein
the transmission data conversion unit is adapted to determine, from a determination result of the received signal strength indicator level determination section, whether or not to convert some of the digital sound data into an error detection bit.

10. A wireless communication system that is adapted to establish a digital link on a wireless channel and that is adapted to perform a communication by a sound packet including a sound signal, which is encoded by means of adaptive differential pulse code modulation, and an error detection code, the wireless communication system comprising:
the communication terminal according to any one of claims 1 to 9; and
a further communication terminal comprising a received data processing unit that is adapted to receive the high frequency ADPCM data and the low frequency ADPCM data, which are sent along with the error detection code, and that is adapted to individually process the high frequency ADPCM data and the low frequency ADPCM data in accordance with a value of the error detection code.

11. The wireless communication system according to claim 10, the further communication terminal further comprising
an ADPCM encoding unit that is adapted to convert the received high frequency ADPCM data into high frequency digital sound data and the received low frequency ADPCM data into low frequency digital sound data.

12. The wireless communication system according to claim 10, wherein
when an error is detected by means of the received error detection code, the received data processing unit is adapted to perform first signal processing on the high frequency ADPCM data that are received along with the error detection code and adapted to perform second signal processing on the low frequency ADPCM data that are received along with the error detection code.

13. The wireless communication system according to claim 10 including the communication terminal according to claim 3, wherein
the received data processing unit is adapted to extract the high frequency ADPCM data and a first error detection code from a received signal, and to extract the low frequency ADPCM data and a second error detection code from the received signal, and
the received data processing unit is adapted to detect an error occurred in the high frequency ADPCM data based on the first error detection code, and to detect an error occurred in the low frequency ADPCM data based on the second error detection code.

14. The wireless communication system according to claim 10 including the communication terminal according to claim 3, wherein
the received data processing unit is adapted to perform third signal processing on the high frequency ADPCM data received along with the error detection code and fourth signal processing on the low frequency ADPCM data received along with the error detection code when an error in a high frequency signal is detected by means of the received first error detection code, and
the received data processing unit is adapted to perform fifth signal processing on the high frequency ADPCM data received along with the error detection code and sixth signal processing on the low frequency ADPCM data received along with the error detection code when an error in a low frequency signal is detected by means of the received second error detection code.

15. The wireless communication system according to claim 14, wherein
the received data processing unit is adapted to convert the high frequency ADPCM data into mute data when an error in the high frequency ADPCM data is detected based on a value of the first error detection code, or the received data processing unit is adapted to convert both the high frequency ADPCM data and the low frequency ADPCM data sent along with the high frequency ADPCM data into mute data when an error in the high frequency ADPCM data is detected based on a value of the first error detection code, or
the received data processing unit is adapted to convert the low frequency ADPCM data into mute data when an error in the low frequency ADPCM data is detected based on a value of the second error detection code, or
the received data processing unit is adapted to convert both the low frequency ADPCM data and the high frequency ADPCM data sent along with the low frequency ADPCM data into mute data when an error in the low frequency ADPCM data is detected based on a value of the second error detection code.

16. The wireless communication system according to claim 10 including the communication terminal according to claim 6, wherein
the received data processing unit has a plurality of data conversion tables, and
the received data processing unit is adapted to select one data conversion table from among the plurality of data conversion tables in accordance with a determination result of the error determination unit, and to convert the high frequency ADPCM data and the low frequency ADPCM data received by means of the thus-selected data conversion table.

17. The wireless communication system according to claim 16, wherein
the received data processing unit is adapted to set an error rate range corresponding to the plurality of data conversion tables and to select a data conversion table conforming to an error rate counted by the error determination unit.

18. The wireless communication system according to claim 17, wherein
the received data processing unit is adapted to convert the low frequency ADPCM data into amplitude attenuation data when the error rate falls within a range between a first threshold value and a second threshold value, or
when the error rate falls within a range which is in excess of a second threshold value, the received data processing unit is adapted to convert the high frequency data into mute data, and converts the low frequency ADPCM data into mute data.

## Patentansprüche

1. Kommunikationsendgerät als Teil eines Drahtloskommunikationssystems, das ausgestaltet ist, eine digitale Verbindung auf einem Drahtloskanal zu etablieren, und das ausgestaltet ist, Kommunikation mittels einem Tonpaket durchzuführen, das ein Tonsignal, das durch adaptive differenzielle Pulscodemodulation codiert wurde, und einen Fehlererfassungscode aufweist, wobei das Kommunikationsendgerät umfasst:
eine ADPCM-Codiereinheit, die ausgestaltet ist, ein abgetastetes Tonsignal in ein Hochfrequenzsignal und ein Niederfrequenzsignal zu unterteilen und das Hochfrequenzsignal und das Niederfrequenzsignal individuell mittels adaptiver differenzieller Pulscodemodulation zu codieren, um dadurch das Hochfrequenzsignal in Hochfrequenz-ADPCM-Daten mit einer ersten Zahl von Bits umzusetzen und das Niederfrequenzsignal in Niederfrequenz-ADPCM-Daten mit einer zweiten Zahl von Bits umzusetzen,
eine Fehlererfassungscodeerzeugungseinheit, die ausgestaltet ist, einen Fehlererfassungscode hinsichtlich der Hochfrequenz-ADPCM-Daten mit der ersten Zahl von Bits und der Niederfrequenz-ADPCM-Daten mit der zweiten Zahl von Bits zu erzeugen,
eine Übermittlungsdatenumsetzungseinheit, die ausgestaltet ist, Daten hinsichtlich einiger aus mehreren Bits, die die Niederfrequenz-ADPCM-Daten bilden, durch den Fehlererfassungscode zu ersetzen, der von der Fehlererfassungscodeerzeugungseinheit erzeugt wurde, und
eine Datenübermittlungseinheit, die ausgestaltet ist, die Hochfrequenz-ADPCM-Daten und die Niederfrequenz-ADPCM-Daten, die teilweise durch die Datenumsetzungseinheit ersetzt wurden, an eine Kommunikationsgegenstelle zu übermitteln.

2. Kommunikationsendgerät nach Anspruch 1, wobei
die erste Zahl von Bits der Hochfrequenz-ADPCM-Daten und die zweite Zahl von Bits der Niederfrequenz-ADPCM-Daten fixiert sind und
die Übermittlungsdatenumsetzungseinheit ausgestaltet ist, Bits durch den Fehlererfassungscode zu ersetzen, der von der Fehlererfassungscodeerzeugungseinheit erzeugt wurde, wobei die ersetzten Bits aus Daten hinsichtlich der zweiten Zahl von Bits, die die Niederfrequenz-ADPCM-Daten bilden, mit Ausnahme von mehreren Bits ausgewählt sind, die in einen adaptiven Dequantisierer der ADPCM-Codiereinheit einzugeben sind.

3. Kommunikationsendgerät nach Anspruch 1, wobei
die Fehlererfassungscodeerzeugungseinheit ausgestaltet ist, einen ersten Fehlererfassungscode hinsichtlich der Hochfrequenz-ADPCM-Daten und einen zweiten Fehlererfassungscode hinsichtlich der Niederfrequenz-ADPCM-Daten zu erzeugen, und
die Übermittlungsdatenumsetzungseinheit ausgestaltet ist, wenigstens zwei Bits an Daten aus den mehreren Bits, die die Niederfrequenz-ADPCM-Daten bilden, durch wenigstens zwei Bits eines Fehlererfassungscodes zu ersetzen, der den ersten Fehlererfassungscode und den zweiten Fehlererfassungscode umfasst.

4. Kommunikationsendgerät nach Anspruch 3, wobei
die Übermittlungsdatenumsetzungseinheit ausgestaltet ist, Daten hinsichtlich von zwei Bits geringerer Ordnung der Niederfrequenz-ADPCM-Daten durch wenigstens zwei Bits eines Fehlererfassungscodes zu ersetzen, der den ersten Fehlererfassungscode und den zweiten Fehlererfassungscode umfasst.

5. Kommunikationsendgerät nach Anspruch 1, wobei
die Fehlererfassungscodeerzeugungseinheit ausgestaltet ist, einen ersten Fehlererfassungscode, der als ein Paritätssignal für Umkehrbits entsprechend der Zahl von "1" in den Hochfrequenz-ADPCM-Daten agiert, und einen zweiten Fehlererfassungscode zu erzeugen, der als ein Paritätssignal für Umkehrbits entsprechend der Zahl von "1" in den Niederfrequenz-ADPCM-Daten agiert, oder
die Fehlererfassungscodeerzeugungseinheit ausgestaltet ist, einen dritten Fehlererfassungscode zu erzeugen, der als ein Paritätssignal für Umkehrbits entsprechend der Zahl von "1" in einer Serie von Daten agiert, die die Hochfrequenz-ADPCM-Daten und die Niederfrequenz-ADPCM-Daten umfasst.

6. Kommunikationsendgerät nach Anspruch 1, ferner mit
einer Fehlerbestimmungseinheit, die ausgestaltet ist, eine Änderung in einer Fehlerrate der digitalen Verbindung zu bestimmen, wobei
die Übermittlungsumsetzungseinheit ausgestaltet ist, auf Basis eines Bestimmungsergebnisses der Fehlerbestimmungseinheit auszuwählen, ob die Niederfrequenz-ADPCM-Daten an eine Kommunikationsgegenstelle nach einem Ersetzen einiger der Niederfrequenz-ADPCM-Daten durch einen Fehlererfassungscode übermittelt werden oder ob die Niederfrequenz-ADPCM-Daten ohne ein Ersetzen der einigen der Niederfrequenz-ADPCM-Daten durch den Fehlererfassungscode übermittelt werden.

7. Kommunikationsendgerät nach Anspruch 6, wobei
die Fehlerbestimmungseinheit ausgestaltet ist, die Fehlerrate entsprechend einem Sync-Daten-Fehler oder einem Fehler zu erhöhen oder verringern, der mit einem Fehlererfassungsbit erfasst wurde, das Steuersignaldaten oder einer Gesamtheit eines Tonpakets hinzugefügt wurde.

8. Kommunikationsendgerät nach Anspruch 7, wobei
die Fehlerbestimmungseinheit ausgestaltet ist, ein Hochzählen eines Fehlerzählers durchzuführen, wenn ein Auftreten eines Fehlers aus einem Wert des Fehlererfassungsbits bestimmt wird, und ein Herunterzählen des Fehlerzählers durchzuführen, wenn ein Fehler nicht auftritt, und die Fehlerrate unter Bezugnahme auf den Fehlerzähler zu erhöhen oder zu verringern.

9. Kommunikationsendgerät nach Anspruch 8, ferner mit
einem Empfangssignalstärkeindikatorniveaubestimmungsabschnitt, der ausgestaltet ist, eine Änderung in dem Empfangssignalstärkeindikator zu bestimmen, indem die digitale Verbindung überwacht wird, wobei die Übermittlungsdatenumsetzungseinheit ausgestaltet ist, aus einem Bestimmungsergebnis des Empfangssignalstärkeindikatorniveaubestimmungsabschnitts zu bestimmen, ob einige der digitalen Tondaten in ein Fehlererfassungsbit umzusetzen sind.

10. Drahtloskommunikationssystem, das ausgestaltet ist, eine digitale Verbindung auf einem Drahtloskanal zu etablieren und eine Kommunikation durch ein Tonpaket mit einem Tonsignal durchzuführen, das mittels adaptiver differenzieller Pulscodemodulation codiert wurde, und einem Fehlererfassungscode, wobei das Drahtloskommunikationssystem umfasst:
das Kommunikationsendgerät nach einem der Ansprüche 1 bis 9, und
ein weiteres Kommunikationsendgerät mit einer Empfangsdatenverarbeitungseinheit, die ausgestaltet ist, die Hochfrequenz-ADPCM-Daten und die Niederfrequenz-ADPCM-Daten zu empfangen, die zusammen mit dem Fehlererfassungscode übermittelt werden, und die ausgestaltet ist, die Hochfrequenz-ADPCM-Daten und die Niederfrequenz-ADPCM-Daten entsprechend zu einem Wert des Fehlererfassungscodes individuell zu verarbeiten.

11. Drahtloskommunikationssystem nach Anspruch 10, wobei das weitere Kommunikationsendgerät ferner eine ADPCM-Codiereinheit aufweist, die ausgestaltet ist, die empfangenen Hochfrequenz-ADPCM-Daten in Hochfrequenz-Digitaltondaten und die empfangenen Niederfrequenz-ADPCM-Daten in Niederfrequenz-Digitaltondaten umzuwandeln.

12. Drahtloskommunikationssystem nach Anspruch 10, wobei
wenn ein Fehler mittels des empfangenen Fehlererfassungscodes erfasst wird, die Empfangsdatenverarbeitungseinheit ausgestaltet ist, eine erste Signalverarbeitung an den Hochfrequenz-ADPCM-Daten durchzuführen, die zusammen mit dem Fehlererfassungscode empfangen werden, und eine zweite Signalverarbeitung an den Niederfrequenz-ADPCM-Daten vorzunehmen, die zusammen mit dem Fehlererfassungscode empfangen werden.

13. Drahtloskommunikationssystem nach Anspruch 10 mit dem Kommunikationsendgerät nach Anspruch 3, wobei
die Empfangsdatenverarbeitungseinheit ausgestaltet ist, die Hochfrequenz-ADPCM-Daten und einen ersten Fehlererfassungscode aus einem empfangenen Signal zu extrahieren und die Niederfrequenz-ADPCM-Daten und einen zweiten Fehlererfassungscode aus dem empfangenen Signal zu extrahieren, und
die Empfangsdatenverarbeitungseinheit ausgestaltet ist, einen Fehler, der in den Hochfrequenz-ADPCM-Daten aufgetreten ist, auf Basis des ersten Fehlererfassungscodes zu erfassen und einen Fehler, der in den Niederfrequenz-ADPCM-Daten aufgetreten ist, auf Basis des zweiten Fehlererfassungscodes zu erfassen.

14. Drahtloskommunikationssystem nach Anspruch 10 mit dem Kommunikationsendgerät nach Anspruch 3, wobei
die Empfangsdatenverarbeitungseinheit ausgestaltet ist, eine dritte Signalverarbeitung an den Hochfrequenz-ADPCM-Daten, die zusammen mit dem Fehlererfassungscode empfangen wurden, und eine vierte Signalverarbeitung an den Niederfrequenz-ADPCM-Daten, die zusammen mit dem Fehlererfassungscode empfangen wurden, durchzuführen, wenn ein Fehler in einem Hochfrequenzsignal mittels des empfangenen ersten Fehlererfassungscodes erfasst wird, und
die Empfangsdatenverarbeitungseinheit ausgestaltet ist, eine fünfte Signalverarbeitung an den Hochfrequenz-ADPCM-Daten, die zusammen mit dem Fehlererfassungscode empfangen wurden, und eine sechste Signalverarbeitung an den Niederfrequenz-ADPCM-Daten, die zusammen mit dem Fehlererfassungscode empfangen wurden, durchzuführen, wenn ein Fehler in einem Niederfrequenzsignal mittels des empfangenen zweiten Fehlererfassungscodes erfasst wird.

15. Drahtloskommunikationssystem nach Anspruch 14, wobei
die Empfangsdatenverarbeitungseinheit ausgestaltet ist, die Hochfrequenz-ADPCM-Daten in Still-Daten umzusetzen, wenn auf Basis eines Werts des ersten Fehlererfassungscodes ein Fehler in den Hochfrequenz-ADPCM-Daten erfasst wird,
oder die Empfangsdatenverarbeitungseinheit ausgestaltet ist, sowohl die Hochfrequenz-ADPCM-Daten als auch die Niederfrequenz-ADPCM-Daten, die zusammen mit den Hochfrequenz-ADPCM-Daten gesendet wurden, in Still-Daten umzusetzen, wenn auf Basis eines Werts des ersten Fehlererfassungscodes ein Fehler in den Hochfrequenz-ADPCM-Daten erfasst wird, oder
die Empfangsdatenverarbeitungseinheit ausgestaltet ist, die Niederfrequenz-ADPCM-Daten in Still-Daten umzuwandeln, wenn auf Basis eines Werts des zweiten Fehlererfassungscodes ein Fehler in den Niederfrequenz-ADPCM-Daten erfasst wird, oder
die Empfangsdatenverarbeitungseinheit ausgestaltet ist, sowohl die Niederfrequenz-ADPCM-Daten als auch die Hochfrequenz-ADPCM-Daten, die zusammen mit den Niederfrequenz-ADPCM-Daten gesendet wurden, in Still-Daten umzuwandeln, wenn auf Basis eines Werts des zweiten Fehlererfassungscodes ein Fehler in den Niederfrequenz-ADPCM-Daten erfasst wird.

16. Drahtloskommunikationssystem nach Anspruch 10 mit dem Kommunikationsendgerät nach Anspruch 6, wobei
die Empfangsdatenverarbeitungseinheit mehrere Datenumsetzungstabellen aufweist und
die Empfangsdatenverarbeitungseinheit ausgestaltet ist, eine Datenumsetzungstabelle aus den mehreren Datenumsetzungstabellen entsprechend einem Bestimmungsergebnis der Fehlerbestimmungseinheit auszuwählen und die empfangenen Hochfrequenz-ADPCM-Daten und die empfangenen Niederfrequenz-ADPCM-Daten mittels der derart ausgewählten Datenumsetzungstabelle umzusetzen.

17. Drahtloskommunikationssystem nach Anspruch 16, wobei
die Empfangsdatenverarbeitungseinheit ausgestaltet ist, einen Fehlerratenbereich entsprechend den mehreren Datenumsetzungstabellen einzustellen und eine Datenumsetzungstabelle auszuwählen, die einer Fehlerrate gerecht wird, die durch die Fehlerbestimmungseinheit gezählt wurde.

18. Drahtloskommunikationssystem nach Anspruch 17, wobei
die Empfangsdatenverarbeitungseinheit ausgestaltet ist, die Niederfrequenz-ADPCM-Daten in Amplitudendämpfungsdaten umzusetzen, wenn die Fehlerrate innerhalb eines Bereichs zwischen einem ersten Schwellenwert und einem zweiten Schwellenwert fällt, oder
wenn die Fehlerrate in einen Bereich jenseits eines zweiten Schwellenwerts fällt, die Empfangsdatenverarbeitungseinheit ausgestaltet ist, die Hochfrequenzdaten in Still-Daten umzusetzen und die Niederfrequenz-ADPCM-Daten in Still-Daten umzusetzen.

## Revendications

1. Terminal de communication en tant que partie d'un système de communication sans fil qui est adapté pour établir une liaison numérique sur un canal sans fil et qui est adapté pour effectuer de la communication par un paquet sonore qui comprend un signal sonore codé par modulation par impulsions et codage différentiel adaptatif ainsi qu'un code de détection d'erreur, ledit terminal de communication comprenant:
une unité de codage MICDA qui est adaptée pour diviser un signal sonore échantillonné en un signal de haute fréquence et en un signal de basse fréquence et pour coder individuellement le signal de haute fréquence et le signal de basse fréquence au moyen de modulation par impulsions et codage différentiel adaptatif afin de convertir ainsi le signal de haute fréquence en données MICDA de haute fréquence ayant un premier nombre de bits, et convertir le signal de basse fréquence en données MICDA de basse fréquence ayant un deuxième nombre de bits,
une unité de génération de code de détection d'erreur qui est adaptée pour générer un code de détection d'erreur quant aux données MICDA de haute fréquence ayant le premier nombre de bits et aux données MICDA de basse fréquence ayant le deuxième nombre de bits,
une unité de conversion de données de transmission qui est adaptée pour remplacer des données quant à certains d'une pluralité de bits qui forment les données MICDA de basse fréquence par le code de détection d'erreur généré par ladite unité de génération de code de détection d'erreur, et
une unité de transmission de données qui est configurée pour transmettre, à un poste opposé de communication, les données MICDA de haute fréquence et les données MICDA de basse fréquence qui ont été remplacées en partie par l'unité de conversion de données.

2. Terminal de communication selon la revendication 1, dans lequel
le premier nombre de bits des données MICDA de haute fréquence et le deuxième nombre de bits des données MICDA de basse fréquence sont fixés, et
l'unité de conversion de données de transmission est adaptée pour remplacer des bits par le code de détection d'erreur généré par l'unité de génération de code de détection d'erreur, dans lequel les bits remplacés sont choisis, à l'exception d'une pluralité de bits à introduire dans un déquantificateur adaptatif de l'unité de codage MICDA, dans des données quant au deuxième nombre de bits qui forment les données MICDA de basse fréquence.

3. Terminal de communication selon la revendication 1, dans lequel
l'unité de génération de code de détection d'erreur est adaptée pour générer un premier code de détection d'erreur relatif aux données MICDA de haute fréquence et un deuxième code de détection d'erreur relatif aux données MICDA de basse fréquence, et
l'unité de conversion de données de transmission est adaptée pour remplacer au moins deux bits de données parmi la pluralité de bits qui forment les données MICDA de basse fréquence par au moins deux bits d'un code de détection d'erreur comprenant le premier code de détection d'erreur et le deuxième code de détection d'erreur.

4. Terminal de communication selon la revendication 3, dans lequel
l'unité de conversion de données de transmission est adaptée pour remplacer des données quant à deux bits d'ordre inférieur des données MICDA de basse fréquence par au moins deux bits d'un code de détection d'erreur comprenant le premier code de détection d'erreur et le deuxième code de détection d'erreur.

5. Terminal de communication selon la revendication 1, dans lequel
l'unité de génération de code de détection d'erreur est adaptée pour générer un premier code de détection d'erreur qui agit comme un signal de parité pour des bits d'inversion en fonction du nombre de "1" dans les données MICDA de haute fréquence, et un deuxième code de détection d'erreur qui agit comme un signal de parité pour des bits d'inversion en fonction du nombre de "1" dans les données MICDA de basse fréquence, ou
l'unité de génération de code de détection d'erreur est adaptée pour générer un troisième code de détection d'erreur qui agit comme un signal de parité pour des bits d'inversion en fonction du nombre de «1» dans une série de données qui comprend les données MICDA de haute fréquence et les données MICDA de basse fréquence.

6. Terminal de communication selon la revendication 1, comprenant en outre
une unité de détermination d'erreur qui est adaptée pour déterminer un changement dans un taux d'erreurs de la liaison numérique, dans lequel
l'unité de conversion de transmission est adaptée pour choisir, sur la base d'un résultat de détermination de l'unité de détermination d'erreur, si les données MICDA de basse fréquence sont transmises à un poste opposé de communication après avoir remplacé certaines des données MICDA de basse fréquence par un code de détection d'erreur, ou si les données MICDA de basse fréquence sont transmises sans remplacer lesdites certaines des données MICDA de basse fréquence par le code de détection d'erreur.

7. Terminal de communication selon la revendication 6, dans lequel
l'unité de détermination d'erreur est adaptée pour augmenter ou diminuer le taux d'erreurs en fonction d'une erreur de données de synchronisation ou d'une erreur détectée par un bit de détection d'erreur ajouté à des données de signal de commande ou à un ensemble d'un paquet sonore.

8. Terminal de communication selon la revendication 7, dans lequel
l'unité de détermination d'erreur est adaptée pour effectuer un comptage progressif d'un compteur d'erreurs lorsqu'une apparition d'une erreur est déterminée à partir d'une valeur du bit de détection d'erreur, et un décomptage du compteur d'erreurs lorsqu'une erreur n'apparaît pas, et pour augmenter ou diminuer le taux d'erreurs en se référant au compteur d'erreurs.

9. Terminal de communication selon la revendication 8, comprenant en outre
une section de détermination de niveau d'indicateur d'intensité de signal reçu qui est adaptée pour déterminer un changement dans l'indicateur d'intensité de signal reçu en surveillant la liaison numérique, dans lequel l'unité de conversion de données de transmission est adaptée pour déterminer, à partir d'un résultat de détermination de la section de détermination de niveau d'indicateur d'intensité de signal reçu, si quelques-unes des données sonores numériques sont à convertir en un bit de détection d'erreur.

10. Système de communication sans fil qui est adapté pour établir une liaison numérique sur un canal sans fil et pour effectuer une communication par un paquet sonore comprenant un signal sonore codé au moyen de modulation par impulsions et codage différentiel adaptatif et un code de détection d'erreur, ledit système de communication sans fil comprenant:
le terminal de communication selon l'une quelconque des revendications 1 à 9, et
un autre terminal de communication ayant une unité de traitement de données reçues qui est adaptée pour recevoir les données MICDA de haute fréquence et les données MICDA de basse fréquence transmises en même temps que le code de détection d'erreur, et qui est adaptée pour traiter individuellement les données MICDA de haute fréquence et les données MICDA de basse fréquence en fonction d'une valeur du code de détection d'erreur.

11. Système de communication sans fil selon la revendication 10, ledit autre terminal de communication comprenant en outre une unité de codage MICDA qui est adaptée pour convertir les données MICDA de haute fréquence reçues en données sonores numériques de haute fréquence et les données MICDA de basse fréquence reçues en données sonores numériques de basse fréquence.

12. Système de communication sans fil selon la revendication 10, dans lequel,
lorsqu'une erreur est détectée au moyen du code de détection d'erreur reçu, l'unité de traitement de données reçues est adaptée pour effectuer un premier traitement de signal sur les données MICDA de haute fréquence qui sont reçus en même temps que le code de détection d'erreur et pour effectuer un deuxième traitement de signal sur les données MICDA de basse fréquence qui sont reçues en même temps que le code de détection d'erreur.

13. Système de communication sans fil selon la revendication 10, comprenant le terminal de communication selon la revendication 3, dans lequel
l'unité de traitement de données reçues est adaptée pour extraire, d'un signal reçu, les données MICDA de haute fréquence et un premier code de détection d'erreur et pour extraire, du signal reçu, les données MICDA de basse fréquence et un deuxième code de détection d'erreur, et
l'unité de traitement de données reçues est adaptée pour détecter une erreur apparue dans les données MICDA de haute fréquence, sur la base du premier code de détection d'erreur, et pour détecter une erreur apparue dans les données MICDA de basse fréquence, sur la base du deuxième code de détection d'erreur.

14. Système de communication sans fil selon la revendication 10, comprenant le terminal de communication selon la revendication 3, dans lequel
l'unité de traitement de données reçues est adaptée pour effectuer un troisième traitement de signal sur les données MICDA de haute fréquence reçues en même temps que le code de détection d'erreur, et un quatrième traitement de signal sur les données MICDA de basse fréquence reçues en même temps que le code de détection d'erreur, lorsqu'une erreur dans un signal de haute fréquence est détectée au moyen du premier code de détection d'erreur reçu, et
l'unité de traitement de données reçues est adaptée pour effectuer un cinquième traitement de signal sur les données MICDA de haute fréquence reçues en même temps que le code de détection d'erreur et un sixième traitement de signal sur les données MICDA de basse fréquence reçues en même temps que le code de détection d'erreur lorsqu'une erreur dans un signal de basse fréquence est détectée au moyen du deuxième code de détection d'erreur reçu.

15. Système de communication sans fil selon la revendication 14, dans lequel
l'unité de traitement de données reçues est adaptée pour convertir les données MICDA de haute fréquence en données silencieuses lorsqu'une erreur dans les données MICDA de haute fréquence est détectée sur la base d'une valeur du premier code de détection d'erreur, ou
l'unité de traitement de données reçues est adaptée pour convertir, en données silencieuses, à la fois les données MICDA de haute fréquence et les données MICDA de basse fréquence transmises en même temps que les données MICDA de haute fréquence, lorsqu'une erreur dans les données MICDA de haute fréquence est détectée sur la base d'une valeur du premier code de détection d'erreur, ou
l'unité de traitement de données reçues est adaptée pour convertir les données MICDA de basse fréquence en données silencieuses lorsqu'une erreur dans les données MICDA de basse fréquence est détectée sur la base d'une valeur du deuxième code de détection d'erreur, ou
l'unité de traitement de données reçues est adaptée pour convertir, en données silencieuses, à la fois les données MICDA de basse fréquence et les données MICDA de haute fréquence transmises en même temps que les données MICDA de basse fréquence, lorsqu'une erreur dans les données MICDA de basse fréquence est détectée sur la base d'une valeur du deuxième code de détection d'erreur.

16. Système de communication sans fil selon la revendication 10, comprenant le terminal de communication selon la revendication 6, dans lequel
l'unité de traitement de données reçues comprend une pluralité de tables de conversion de données, et
l'unité de traitement de données reçues est adaptée pour choisir une table de conversion de données dans la pluralité de tables de conversion de données conformément à un résultat de détermination de l'unité de détermination d'erreur, et pour convertir les données MICDA de haute fréquence reçues et les données MICDA de basse fréquence reçues par l'intermédiaire de la table de conversion de données ainsi choisie.

17. Système de communication sans fil selon la revendication 16, dans lequel
l'unité de traitement de données reçues est adaptée pour ajuster une plage de taux d'erreurs conformément à la pluralité de tables de conversion de données et pour choisir une table de conversion de données qui satisfait à un taux d'erreurs compté par l'unité de détermination d'erreur.

18. Système de communication sans fil selon la revendication 17, dans lequel
l'unité de traitement de données reçues est adaptée pour convertir les données MICDA de basse fréquence en données d'atténuation d'amplitude lorsque le taux d'erreurs se situe dans une plage comprise entre une première valeur de seuil et une deuxième valeur de seuil, ou,
lorsque le taux d'erreurs se situe dans une plage qui est au-delà d'une deuxième valeur de seuil, l'unité de traitement de données reçues est adaptée pour convertir les données de haute fréquence en données silencieuses et pour convertir les données MICDA de basse fréquence en données silencieuses.
